# EUROPÄISCHE PATENTANMELDUNG

(11) **EP 2 886 936 A1**
(43) Veröffentlichungstag der Anmeldung: **24.06.2015**
(21) Anmeldenummer: 13199313.1
(22) Anmeldetag: 23.12.2013
(51) Int. Cl.: F21S 8/10, H01L 51/52, H05B 33/08

(54) **Leuchtmittel und hiermit ausgestattete Kraftfahrzeugleuchte**

(71) Anmelder: odelo GmbH, 70329 Stuttgart (DE)
(72) Erfinder: Vollmer, Marco, 71332 Waiblingen (DE); Schwegler, Veit, 70372 Stuttgart (DE)
(74) Vertreter: Benninger, Johannes

(57) **Zusammenfassung**

Es werden ein Leuchtmittel (100) und eine mindestens ein solches Leuchtmittel (100) umfassende Kraftfahrzeugleuchte (01) beschrieben. Das Leuchtmittel (100) umfasst mindestens eine OLED (20) als Lichtquelle. Das Leuchtmittel (100) zeichnet sich durch mindestens ein mit wenigstens einer OLED (20) des Leuchtmittels (100) in zumindest wärmeleitendem Kontakt stehendes Temperierelement (200) aus. In der Kraftfahrzeugleuchte ist zumindest ein derartiges Leuchtmittel (100) zur Erfüllung wenigstens einer ihrer Lichtfunktionen vorgesehen.

## Beschreibung

Die Erfindung betrifft ein Leuchtmittel mit mindestens einer OLED als Lichtquelle gemäß dem Oberbegriff des Anspruchs 1 und eine mit mindestens einem derartigen Leuchtmittel ausgestattete Kraftfahrzeugleuchte gemäß dem Oberbegriff des Anspruchs 13.

Eine typische Kraftfahrzeugleuchte umfasst einen im Wesentlichen von einem Leuchtengehäuse und einer Lichtscheibe umschlossenen Leuchteninnenraum und mindestens ein darin beherbergtes, mindestens eine Lichtquelle umfassendes Leuchtmittel für wenigstens eine Lichtfunktion der Kraftfahrzeugleuchte.

Jede Kraftfahrzeugleuchte erfüllt je nach Ausgestaltung eine oder mehrere Aufgaben bzw. Funktionen. Zur Erfüllung jeder Aufgabe bzw. Funktion ist eine Lichtfunktion der Kraftfahrzeugleuchte vorgesehen. Lichtfunktionen sind beispielsweise bei einer Ausgestaltung als Scheinwerfer eine die Fahrbahn ausleuchtende Funktion, oder bei einer Ausgestaltung als Signalleuchte eine Signalfunktion, wie beispielsweise eine Wiederholblinklichtfunktion zur Fahrtrichtungsanzeige oder eine Bremslichtfunktion zur Anzeige einer Bremstätigkeit, oder z.B. einer Begrenzungslichtfunktion, wie etwa einer Rücklichtfunktion, zur Sicherstellung einer Sichtbarkeit des Kraftfahrzeugs bei Tag und/oder Nacht, wie etwa bei einer Ausgestaltung als Heckleuchte oder Tagfahrleuchte. Beispiele für Kraftfahrzeugleuchten sind am Fahrzeugbug, an den Fahrzeugflanken und/oder an den Seitenspiegeln sowie am Fahrzeugheck angeordnete Blinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Jede Lichtfunktion muss dabei eine beispielsweise gesetzlich vorgegebene Lichtverteilung erfüllen. Die Lichtverteilung legt dabei mindestens einzuhaltende, umgangssprachlich als Helligkeit bezeichnete Lichtströme in zumindest einzuhaltenden Raumwinkelbereichen fest.

Für die einzelnen Lichtfunktionen sind zum Teil unterschiedliche Helligkeiten bzw. Sichtweiten sowie zum Teil unterschiedliche Lichtfarben zugeordnet.

Wenigstens einer Lichtquelle des Leuchtmittels einer Kraftfahrzeugleuchte können ein oder mehrere zur Ausformung einer Lichtverteilung beitragende Optikelemente zur Lichtlenkung zugeordnet sein.

Die Lichtscheibe ist durch eine heutzutage meist aus einem Kunststoff hergestellte, transparente Abdeckung gebildet, welche den Leuchteninnenraum abschließt und die darin beherbergten Bauteile, wie etwa ein oder mehrere Leuchtmittel, Reflektoren sowie alternativ oder zusätzlich vorgesehene Optikelemente gegen Witterungseinflüsse schützt.

Das Leuchtengehäuse bzw. der Leuchteninnenraum kann in mehrere Kammern mit jeweils eigenen Lichtquellen und/oder Leuchtmitteln und/oder Optikelementen sowie gegebenenfalls Lichtscheiben unterteilt sein, von denen mehrere Kammern gleiche und/oder jede Kammer eine andere Lichtfunktionen erfüllen kann.

Bei den erwähnten Optikelementen kann es sich um wenigstens einen Reflektor und/oder um mindestens eine Linse und/oder um eine oder mehrere im Strahlengang zwischen wenigstens einer Lichtquelle des Leuchtmittels und der Lichtscheibe angeordnete Optikscheiben oder dergleichen handeln.

Beispielsweise kann in dem Leuchteninnenraum mindestens ein hinter wenigstens einer Lichtquelle zumindest eines Leuchtmittels angeordneter Reflektor untergebracht sein. Der Reflektor kann zumindest zum Teil durch ein separates Bauteil und/oder durch wenigstens einen Teil des Leuchtengehäuses selbst gebildet sein, beispielsweise vermittels einer zumindest teilweisen, reflektierenden Beschichtung.

Die Lichtscheibe selbst kann alternativ oder zusätzlich als ein Optikelement ausgebildet sein, beispielsweise indem sie vorzugsweise an deren Innenseite mit einer zur Erzeugung einer oder mehrerer zuvor erwähnter Lichtverteilungen beitragenden optischen Struktur versehen ist. Hierdurch kann gegebenenfalls auf eine Optikscheibe verzichtet werden.

Beispiele für Kraftfahrzeugleuchten sind am Fahrzeugbug, an den Fahrzeugflanken und/oder an den Seitenspiegeln sowie am Fahrzeugheck angeordnete Wiederholblinkleuchten, Ausstiegsleuchten, beispielsweise zur Umfeldbeleuchtung, Begrenzungsleuchten, Bremsleuchten, Nebelleuchten, Rückfahrleuchten, sowie typischerweise hoch gesetzte dritte Bremsleuchten, so genannte Central, High-Mounted Braking Lights, Tagfahrleuchten, Scheinwerfer und auch als Abbiege- oder Kurvenlicht verwendete Nebelscheinwerfer, sowie Kombinationen hiervon.

Eine solche Kombination ist beispielsweise regelmäßig in den bekannten Heckleuchten verwirklicht. In diesen kommen beispielsweise Wiederholblinkleuchten, Begrenzungsleuchten, Bremsleuchten, Nebelleuchten sowie Rückfahrleuchten zum Einsatz, um nur eine von vielen in Heckleuchten verwirklichten Kombinationen zu nennen. Weder erhebt diese Aufzählung Anspruch auf Vollständigkeit, noch bedeutet dies, dass in einer Heckleuchte alle genannten Leuchten kombiniert werden müssen. So können beispielsweise auch nur zwei oder drei der genannten oder auch anderer Leuchten in einem gemeinsamen Leuchtengehäuse einer Heckleuchte miteinander kombiniert sein.

Als Lichtquellen kommen in Kraftfahrzeugleuchten Glühlampen, Gasentladungslampen sowie unter anderem wegen ihres geringen Stromverbrauchs und geringen Bauraumbedarfs vermehrt Leuchtdioden zum Einsatz. Letztere bestehen aus mindestens einem Lichtemittierende-Diode-Halbleiter-Chip, kurz LED-Chip, sowie wenigstens einer beispielsweise durch Spritzgießen angeformten, den mindestens einen LED-Chip ganz oder teilweise umhüllenden Primäroptik. Auch sind Kraftfahrzeugleuchten bekannt, in denen reine LED-Chips ohne angeformte Primäroptiken zum Einsatz kommen. Im Folgenden wird deshalb der Einfachheit halber nicht zwischen Leuchtdiode und LED-Chip unterschieden und statt dessen einheitlich der Begriff LED stellvertretend für beide Ausgestaltungen verwendet, es sei denn, es ist explizit etwas anderes erwähnt. Herausragende Eigenschaften von LEDs im Vergleich zu anderen, konventionellen Lichtquellen von Leuchtmitteln sind eine wesentlich längere Lebensdauer und eine wesentlich höhere Lichtausbeute bei gleicher Leistungsaufnahme. Dadurch und unter anderem auch wegen ihrer kompakteren Abmessungen können durch Verwendung von LEDs als Lichtquelle von Leuchtmitteln besonders kompakte Kraftfahrzeugleuchten verwirklicht werden, die an fast jede nur erdenkliche Einbausituation angepasst sein können.

In Verbindung mit der Verwendung von LEDs als Lichtquellen in einer Kraftfahrzeugleuchte ist bekannt, mehrere LEDs von außerhalb des Leuchteninnenraums durch die Lichtscheibe hindurch sichtbar auf einer Fläche anzuordnen, welche bei eingeschalteten LEDs durch die Lichtscheibe hindurch als leuchtende Fläche wahrgenommen wird, oder die LEDs in einem von außerhalb des Leuchteninnenraums durch die Lichtscheibe hindurch nicht einsehbaren Bereich anzuordnen, wobei das von den LEDs abgestrahlte Licht über einen Reflektor und/oder einen Lichtleiter in Richtung der Lichtscheibe verteilt und umgelenkt wird, welcher Reflektor und/oder welcher Lichtleiter dann von außerhalb des Leuchteninnenraums durch die Lichtscheibe hindurch gesehen als leuchtende Fläche wahrgenommen wird, von welcher aus das Licht schließlich durch die Lichtscheibe hindurch aus dem Leuchteninnenraum austreten kann.

Nachteilig an beiden Varianten ist neben dem immer noch teils erheblichen Bauraumbedarf im Leuchteninnenraum der notwendige, nicht unerhebliche Aufwand, um ein homogenes Erscheinungsbild der leuchtenden Fläche zu erhalten.

Eine Behebung dieser Nachteile verspricht die Verwendung organischer Leuchtdioden (Organic Light Emitting Diode; OLED) als Lichtquellen.

Eine OLED ist ein leuchtendes Dünnschichtbauelement aus organischen halbleitenden Materialien mit mindestens einer Emitterschicht, das sich von den anorganischen Leuchtdioden (LED) dadurch unterscheidet, dass keine einkristallinen Materialien erforderlich sind. Im Vergleich zu anorganischen LEDs lassen sich organische Leuchtdioden daher in kostengünstiger Dünnschichttechnik herstellen. OLEDs ermöglichen dadurch die Herstellung flächiger Lichtquellen, die einerseits sehr dünn und andererseits als durch die Lichtscheibe einer Kraftfahrzeugleuchte hindurch sichtbare leuchtende Fläche eingesetzt einen besonders homogenes Erscheinungsbild aufweisen.

OLEDs weisen eine Schichtstapelhöhe in der Größenordnung von etwa 100 nm auf. Die Stapel sind eingeschlossen zwischen metallischen Schichten für Anode und Kathode. Zum Schutz gegen Wasser, Sauerstoff sowie zum Schutz gegen andere Umwelteinflüsse, wie etwa Kratzbeschädigung und/oder Druckbelastung sind OLEDs typischerweise mit einem anorganischen Material insbesondere mit Glas verkapselt. Zwar gibt es Anstrengungen, das Glas durch Kunststoff zu ersetzen, die jedoch nicht vom gewünschten Erfolg gekrönt sind, weil die Dichtigkeit der alternativen Materialien für die Verkapselung nicht ausreichend gut genug ist.

Die OLEDs müssen dabei möglichst frei von mechanischen Spannungen (spannungsfrei) und Momenten (momentfrei) aufgenommen werden, da die zur Verkapselung der Schichtstapel vorgesehenen Glasplättchen mit jeweils etwa 0,7 bis 1,2 mm relativ dünn und damit auch relativ zerbrechlich sind. Vor allem sind auch die Glasaußenkanten empfindlich gegen mechanische Belastungen und können leicht ausbrechen.

Teilweise sind die Gläser noch dünner, sofern keine Dünnschichtverkapselung in den Schichtstapel zugefügt wird, da dann mit einem Kavitätsglas gearbeitet wird. Dabei wird das Glas auf der Kathode beispielsweise ausgefräst, um den so genannten Getter unterzubringen, dessen Aufgabe es ist, Feuchtigkeit, die beispielsweise durch Diffusion durch die Kleberschicht zwischen den zwei Glasplatten eintreten kann, im Inneren der OLED aufzunehmen und die organischen Schichten hiervor zu schützen.

Das Kavitätsglas hat damit im mittleren Bereich Dicken von etwa 0,5 mm und weniger und ist damit sehr empfindlich gegen Druckbelastungen. Auch darf durch Druckbelastung der Getter, der in entsprechend ausgeführten OLEDs mit etwas Abstand zu den organischen Schichten angeordnet ist, nicht auf die organischen Schichten drücken, da hierdurch die wenige Nanometer dicken Schichten beschädigt werden könnten, was zu einem teilweisen oder totalen Ausfall der OLED führen würde.

Um OLEDs als Lichtquellen von für den Einsatz in Kraftfahrzeugleuchten vorgesehenen Leuchtmitteln verwenden zu können, müssen diese daher möglichst spannungs- und momentfrei aufgenommen werden, da die zur Verkapselung der Schichtstapel vorgesehenen Glasplättchen relativ dünn und damit auch relativ zerbrechlich sind. Vor allem sind auch die Glasaußenkanten empfindlich gegen mechanische Belastungen und können leicht ausbrechen.

Durch EP 2 592 331 A1 ist eine Kraftfahrzeugleuchte mit einer vermittels eines Halters im Leuchteninnenraum untergebrachten OLED bekannt. Der Halter ist dabei als ein die OLED zumindest bereichsweise umgebender Rahmen ausgeführt. Zum Schutz ihrer Glasplättchen vor Zerstörung durch Vibrationen kann dabei vorgesehen sein, zwischen dem Halter und der OLED ein Elastomer anzuordnen. Offen bleibt hierbei, wie die OLED spannungsfrei gehalten werden soll, damit ihre Glasplättchen nicht zerstört und/oder beschädigt werden.

Durch DE 10 2009 009 087 A1 ist bekannt, im Leuchteninnenraum einer Kraftfahrzeugleuchte eine OLED als Lichtquelle eines zur Erfüllung einer zweiten Lichtfunktion vorgesehenen Leuchtmittels im Strahlengang zwischen einem zur Erfüllung einer ersten Lichtfunktion vorgesehenen Leuchtmittels und einer Lichtscheibe anzuordnen. Die OLED ist dabei zwischen zwei Klammern einer Halterung gespannt. Eine spannungsfreie Halterung der OLED zum Schuz deren Glasplättchen vor Zerstörung und/oder Beschädigung ist damit nicht sichergestellt.

Durch DE 20 207 799 U1 ist eine Kraftfahrzeugleuchte mit einer auf einem Träger aufsitzenden Lichtscheibe und einer zwischen Lichtscheibe und dem Träger angeordneten OLED bekannt.

Durch DE 10 2007 021 179 A1 ist bekannt, eine OLED in eine transparente, einen Leuchteninnenraum begrenzende Rückwand einer Kraftfahrzeugleuchte zu integrieren.

Durch DE 10 2005 024 838 A1 ist ein für den Innen- oder Au βenbereich eines Fahrzeugs vorgesehenes Leuchtmittel mit einer OLED als Lichtquelle bekannt. Das Leuchtmittel umfasst eine auf einem Träger angeordnete OLED. Die OLED ist beispielsweise durch Aufkleben mit einem flächigen Träger verbunden. Der beispielsweise im Spritzguss hergestellte Träger weist ein Anschlussmittel auf, mit dem das Leuchtmittel mit dem Kraftfahrzeug elektrisch und mechanisch verbindbar ist. Das Anschlussmittel in Form eines Zapfens mit Rastmitteln ist mittig auf der Rückseite des Trägers angeordnet. Nachteilig hieran ist, dass beim Ein- und Ausstecken des Trägers damit die Gefahr einer Zerstörung der die Vorder- und Rückseiten der OLED bildenden Glasplättchen besteht.

Durch US 2011/089811 A1 ist ein Leuchtmittel mit einer OLED als Lichtquelle bekannt. Die OLED ist auf einem gekrümmten Träger angeordnet. Der Träger wird mit der Krümmung hergestellt. Die ebene OLED wird auf den Träger aufgebracht, indem dieser elastisch in ebene Form gebracht wird. Nach dem Aufbringen der OLED wird die elastische Verformung des Trägers aufgehoben, so dass der OLED die Krümmung des Trägers aufgezwungen wird. Nachteilig hieran ist, dass die OLED nicht frei von mechanischen Spannungen gehalten ist und dadurch die Gefahr einer Zerstörung des zumindest einen als Basis der OLED dienenden Glasplättchens besteht.

Durch EP 2 474 448 A1 ist ein Innenrückblickspiegel mit einer OLED als Blendschutz bekannt. Das gesamte Spiegelglas des Innenrückblickspiegels ist hierbei mit der OLED versehen. Ein Umgebungslichtsensor erfasst die Scheinwerfer anderer Fahrzeuge und dimmt deren Blendwirkung durch Betrieb der OLED.

Um OLEDs als Lichtquellen von für den Einsatz in Kraftfahrzeugleuchten vorgesehenen Leuchtmitteln verwenden zu können, müssen jedoch zusätzlich zur mechanischen Stabilität beispielsweise durch technische Anforderungen vorgegebene Umgebungsbedingungen beherrscht werden, wie sie beim Einsatz in Kraftfahrzeugleuchten auftreten.

Technische Anforderungen bezüglich mechanischer und thermischer Stabilität sind im Automobilbereich beispielsweise durch den Standard LV 124 vorgegeben.

Eine typische technische Anforderung hieraus bezüglich thermischer Stabilität betrifft den sowohl im Warmzustand bei eingeschaltetem Leuchtmittel, als auch im Kaltzustand, bei ausgeschaltetem Leuchtmittel sowie bei der Inbetriebnahme aus dem Kaltzustand zu ertragenden Temperaturbereich, innerhalb welchen Temperaturbereichs sämtliche zur Erfüllung einer Lichtfunktion in einer Kraftfahrzeugleuchte verbauten Leuchtmittel die Lichtverteilungen der durch sie zu bewältigenden Lichtfunktionen jeweils vollständig erfüllen leisten müssen. Die diesbezügliche technische Anforderung sieht im Kraftfahrzeug- bzw. Automobilbereich einen Temperaturbereich von -40°C bis 80°C vor.

Dennoch sind höhere oder tiefere Temperaturen als in den genannten Anforderungen in der Realität nicht auszuschließen und möglich. Beispielsweise bei Sonneneinstrahlung in heißen Wüstengebieten können in einer Leuchte oder an Leuchtenteilen auch Temperaturen von über 80°C auftreten, ebenso wie in arktischen Regionen beispielsweise bei klarem Nachthimmel Temperaturen von unter -40°C auftreten können.

Bei der Verwendung von OLEDs ergibt sich hierbei die spezielle Problemstellung, dass sich bei gleichbleibend angelegtem Strom an die OLED die Spannung über einen großen Bereich mit der Temperatur ändert. Speziell im Bereich unter etwa 0 °C steigt die Spannung sehr stark an. Dies unterscheidet sie - elektrisch gesehen - stark von LEDs. Hierdurch wird die elektrische Ansteuerung der OLED mittels Schaltungen schwierig oder mit der bislang für LEDs eingesetzten Schaltungstechnik zumindest für den Automobilbereich unmöglich.

Die voranstehenden Ausführungen zur Erfüllung von Lichtverteilungen von Lichtfunktionen zumindest im durch die technischen Anforderungen an Kraftfahrzeugleuchten vorgegebenen Temperaturbereich bei der Verwendung von OLEDs als Lichtquellen von Leuchtmitteln in Kraftfahrzeugleuchten finden beim Stand der Technik ungeachtet der damit verfolgten heren Ziele ebensowenig Beachtung, wie die weiter voranstehenden Ausführungen zur Erfüllung der durch die technischen Anforderungen an Kraftfahrzeugleuchten vorgegebenen mechanischen Stabilität.

Eine Aufgabe der Erfindung ist es, ein beispielsweise mit einem Träger ausgestattetes Leuchtmittel mit mindestens einer beispielsweise von einem gegebenenfalls vorgesehenen Träger gehaltenen OLED sowie eine mit mindestens einem solchen Leuchtmittel ausgestattete Kraftfahrzeugleuchte zu entwickeln, welche die Verwendung von OLEDs zumindest im durch die technischen Anforderungen an Kraftfahrzeugleuchten vorgegebenen Temperaturbereich gestatten.

Die Aufgabe wird jeweils gelöst mit den Merkmalen der unabhängigen Ansprüche.

Ein erster Gegenstand der Erfindung betrifft demnach ein Leuchtmittel umfassend mindestens eine OLED als Lichtquelle.

Das Leuchtmittel zeichnet sich durch mindestens ein mit wenigstens einer OLED des Leuchtmittels in zumindest wärmeleitendem Kontakt stehendes, vorzugsweise elektrisches Temperierelement aus.

Das elektrische Temperierelement umfasst mindestens ein Heizelement und/oder mindestens ein Kühlelement.

Als Heizelement kommen beispielsweise eine oder mehrere Heizwendeln und/oder Heizwiderstände in Frage.

Als Kühlelement kommen beispielsweise ein oder mehrere Peltier-Elemente in Frage.

Grundsätzlich können sowohl der Thomson-Effekt als auch der Peltier-Effekt genutzt werden, um die OLED zu kühlen.

OLEDs weisen als stromgetriebene Leuchtmittel unterhalb von Betriebstemperaturen von etwa 25°C einen großen Spannungsanstieg bei sinkender Temperatur auf. Verglichen mit den I-U-Diagrammen von LEDs verhalten sie sich damit deutlich verschieden mit einer starken Verschiebung und Verlaufsänderung der Kennlinie im I-U-Diagramm unterhalb einer Temperatur von 25°C. Um diesem Effekt einer starken Verschiebung und Verlaufsänderung der Kennlinie mit der Temperatur einer OLED im Vergleich zu einer LED entgegenzuwirken wird ein Temperierelement für die OLED vorgesehen, das beispielsweise am OLED-Träger angebracht ist.

Als zur Erhöhung der Temperatur der OLED vorzugsweise unterhalb einer Schwellentemperatur von 0°C vorgesehenes Heizelement kann z. B. eine bekannte Technologie eingesetzt werden, beispielsweise in Form einer Heizfolie, die am Träger angebracht ist und mit Wärmedrahten durchzogen ist. Auch ist es möglich eine Platine mit z. B. Widerständen am Halter anzubringen, um mit der Elektronik den Halter mit OLED zu heizen bzw. zu temperieren. Da tiefe Temperaturen bei der Ansteuerung den kritischeren Fall darstellen, ist die Aufwärmung der OLEDs im Vergleich zu deren Kühlung wichtiger. Die Beheizung kann bei Betrieb der OLED oberhalb einer Schwellentemperatur abgeschaltet werden, weil die OLED durch deren Betrieb mit der Zeit ohnehin warm wird. Dadurch ist die Temperierung vorzugsweise im Zeitbereich um das Anschalten besonders wichtig.

Das Leuchtmittel kann einen beispielsweise ebenfalls mit wenigstens einer OLED des Leuchtmittels in zumindest wärmeleitendem Kontakt stehenden Temperaturfühler bzw. Temperatursensor umfassen, der ein einer von ihm erfassten Temperatur, beispielsweise einer Umgebungstemperatur der mindestens einen OLED des Leuchtmittels oder der Temperatur mindestens einer OLED des Leuchtmittels, proportionales Ausgangssignal erzeugt.

Das Leuchtmittel kann darüber hinaus einen mit dem Temperatursensor elektrisch verbundenen Schaltkreis umfassen, der vom Ausgangssignal des Temperatursensors gesteuert wird.

Der Schaltkreis ist mit dem vorzugsweise elektrischen Temperierelement verbunden und steuert dessen Stromzufuhr, um auf die Temperatur mindestens einer OLED des Leuchtmittels Einfluss zu nehmen.

Der Schaltkreis kann einen Schalter umfassen.

Der Temperatursensor kann im einfachsten Fall zumindest mit einer als Schalter ausgebildeten Partie des Schaltkreises verbunden sein, welcher bei einem einer von dem Temperatursensor erfassten Temperatur, die kleiner ist, als eine vorgegebene Schwellentemperatur von beispielsweise 0°C proportionalen Ausgangssignal von dem Temperatursensor derart geschaltet wird, dass ein vom vorzugsweise elektrischen Temperierelement umfasstes Heizelement dann bestromt und dadurch betrieben wird und hiermit die mindestens eine mit dem Heizelement zumindest in wärmeleitendem Kontakt stehende OLED beheizt wird, und welcher bei einem einer von dem Temperatursensor erfassten Temperatur, die größer ist, als eine vorgegebene Schwellentemperatur von beispielsweise 0°C proportionalen Ausgangssignal von dem Temperatursensor derart geschaltet wird, dass das Heizelement dann nicht bestromt und dadurch auch nicht betrieben wird und hiermit die mindestens eine mit dem Heizelement zumindest in wärmeleitendem Kontakt stehende OLED nicht beheizt wird.

Alternativ oder zusätzlich kann der Schaltkreis einen Proportionalregler umfassen, der das vom vorzugsweise elektrischen Temperierelement umfasste Heizelement unterhalb einer vorgegebenen Schwellentemperatur um so höher bestromt, je niedriger die vom Temperatursensor erfasste Temperatur ist, und dadurch dessen Heizwirkung steigert, je niedriger die vom Temperatursensor erfasste Temperatur ist.

Der Schaltkreis kann eine Kombination aus einem Schalter und einem Proportionalregler umfassen, wobei der Schalter eine generelle Stromunterbrechung für das bevorzugt elektrische Heizelement bei einem einer von dem Temperatursensor erfassten Temperatur, die größer ist, als eine vorgegebene Schwellentemperatur von beispielsweise 0°C proportionalen Ausgangssignal besorgt, und der Proportionalregler eine mit einem einer abnehmenden, von dem Temperatursensor erfassten Temperatur, die kleiner ist, als eine vorgegebene Schwellentemperatur von beispielsweise 0°C proportionalen Ausgangssignal zunehmende Bestromung des vom Temperierelement umfassten Heizelements besorgt.

Der Schaltkreis kann alternativ oder zusätzlich zu den beschriebenen Varianten ein oder mehrere Proportional- und/oder Differential- und/oder Integralglieder (P-, D-, I-Glieder) und/oder Schalter umfassen um eine gewünschte Regelcharakteristik eines vom Temperierelement umfassten Heizelements zu erhalten.

Es ist ersichtlich, dass die Erfindung in jedem Fall dadurch verwirklicht sein kann, OLEDs im Temperaturbereich beispielsweise unter 0°C zu beheizen. Dies kann erfolgen, indem die OLED beispielsweise auf einem Träger mit hinterlegtem, beispielsweise als elektrische Heizwendel ausgeführtem elektrischem Heizelement, ähnlich einer Beheizung eines Spiegelglases eines Außenrückblickspiegels angeordnet wird, oder indem beispielsweise auf ein vorzugsweise rückseitiges Glasplättchen einer OLED ein Heizelement beispielsweise in Form einer solchen elektrischen Heizwendel aufgebracht wird, und die Heizwendel unter Verwendung einer entsprechenden Sensorik unterhalb einer vorgegebenen Grenztemperatur betrieben wird.

Der Temperatursensor kann darüber hinaus mit einer als Schalter ausgebildeten Partie des Schaltkreises verbunden sein, welcher bei einem einer von dem Temperatursensor erfassten Temperatur, die größer ist, als eine vorgegebene Schwellentemperatur von beispielsweise 80°C proportionalen Ausgangssignal von dem Temperatursensor derart geschaltet wird, dass ein vom vorzugsweise elektrischen Temperierelement umfasstes Kühlelement dann bestromt und dadurch betrieben wird und hiermit die mindestens eine mit dem Kühlelement zumindest in wärmeleitendem Kontakt stehende OLED gekühlt wird, und welcher bei einem einer von dem Temperatursensor erfassten Temperatur, die kleiner ist, als eine vorgegebene Schwellentemperatur von beispielsweise 80°C proportionalen Ausgangssignal von dem Temperatursensor derart geschaltet wird, dass das Kühlelement dann nicht bestromt und dadurch auch nicht betrieben wird und hiermit die mindestens eine mit dem Kühlelement zumindest in wärmeleitendem Kontakt stehende OLED nicht gekühlt wird.

Alternativ oder zusätzlich kann der Schaltkreis einen Proportionalregler umfassen, der das vom vorzugsweise elektrischen Temperierelement umfasste Kühlelement beispielsweise oberhalb einer vorgegebenen Schwellentemperatur um so höher bestromt, je höher die vom Temperatursensor erfasste Temperatur ist, und dadurch dessen Kühlwirkung steigert, je höher die vom Temperatursensor erfasste Temperatur ist.

Der Schaltkreis kann eine Kombination aus einem Schalter und einem Proportionalregler umfassen, wobei der Schalter eine generelle Stromunterbrechung für das vorzugsweise elektrische Kühlelement bei einem einer von dem Temperatursensor erfassten Temperatur, die kleiner ist, als eine vorgegebene Schwellentemperatur von beispielsweise 65°C proportionalen Ausgangssignal besorgt, und der Proportionalregler eine mit einem einer zunehmenden, von dem Temperatursensor erfassten Temperatur, die größer ist, als eine vorgegebene Schwellentemperatur von beispielsweise 65°C proportionalen Ausgangssignal zunehmende Bestromung des Kühlelements besorgt.

Der Schaltkreis kann alternativ oder zusätzlich zu den beschriebenen Varianten ein oder mehrere Proportional- und/oder Differential- und/oder Integralglieder (P-, D-, I-Glieder) und/oder Schalter umfassen, um eine gewünschte Regelcharakteristik eines vom Temperierelement umfassten Kühlelements zu erhalten.

Wichtig ist hervorzuheben, dass die Schwellentemperaturen, bei denen beispielsweise das Heizelement und/oder das Kühlelement jeweils aktiviert und deaktiviert werden, nicht identisch sein müssen. So ist beispielsweise denkbar, dass die durch Betrieb des Heizelements erfolgende Beheizung bei Unterschreitung der vom Temperatursensor erfassten Temperatur unter 0°C eingeschaltet wird, und erst bei Überschreiten einer vom Temperatursensor erfassten Temperatur von beispielsweise 15°C wieder ausgeschaltet wird. Ebenso ist denkbar, dass die durch Betrieb des Kühlelements erfolgende Kühlung bei Überschreitung der vom Temperatursensor erfassten Temperatur von beispielsweise 80 °C eingeschaltet wird, und erst bei Unterschreiten einer vom Temperatursensor erfassten Temperatur unter beispielsweise 65°C wieder ausgeschaltet wird. Auch können die Schwellentemperaturen andere Werte als die angegebenen aufweisen, beispielsweise um Ungenauigkeiten der Temperaturerfassung auszugleichen, wie sie beispielsweise durch Wärmeleitung zwischen Wärmequelle und/oder Wärmesenke und OLED entstehen können, um die OLED innerhalb eines zu deren Betrieb optimalen Temperaturbereichs zu temperieren.

Die Erfindung löst damit das Problem, OLEDs in einem Temperaturbereich von - 40°C bis +80°C und damit für den Einsatz im Kraftfahrzeug- bzw. Automobilbereich vorzusehen, obgleich OLEDs im Vergleich zu konventionellen LEDs ein wesentlich anderes Temperaturverhalten aufweisen, weil deren Spannung bei gleichbleibendem Strom bei Temperaturen unter 0°C sehr stark ansteigt. Die Erfindung zeigt Maßnahmen auf, die getroffen werden können, um den Spannungsverlauf von OLEDs insbesondere im für den Einsatz im Kraftfahrzeug- bzw. Automobilbereich relevanten Temperaturbereich von -40°C bis +80°C in den Griff zu bekommen.

Vorteile gegenüber dem Stand der Technik ergeben sich unter Anderem durch einen insbesondere bei Umgebungstemperaturen von unter 0 °C gleichbleibenden Strom-Spannungs-Verlauf von OLEDs, wodurch diese im Kraftfahrzeug- bzw. Automobilbereich einsetzbar werden.

Zusätzliche Vorteile ergeben sich unter Anderem dadurch, dass keine aufwendigen elektrischen Schaltungen nötig sind, um den Strom über einen großen Spannungsbereich konstant zu halten. Aktuell ist dies mit z. B. DC/DC-Wandlerschaltungen (Gleichspannungswandler) möglich, die allerdings teuer sind. Auch führen die hierin verbauten Spulen zu Abstrahlung und/oder Einstrahlung von relativ starken elektromagnetischen Feldern, wodurch es jedoch zu Problemen hinsichtlich elektromagnetischer Verträglichkeit (EMV) innerhalb des Leuchtmittels und damit in einer mit einem solchen Leuchtmittel ausgestatteten Kraftfahrzeugleuchte kommen kann. Daher muss hierfür eine spezielle Abschirmung der Elektronik erfolgen einhergehend mit einem zusätzlichen Schirmungsbauteil.

Anstelle eines zusätzlichen Bauteils kann die Abschirmung der Elektronik auch durch einen Kühlkörper realisiert werden, der gegebenenfalls schon vorhanden ist. Hierbei wird das sich hinsichtlich EMV kritisch verhaltende Bauteil, wie etwa eine Spule, das beispielsweise an einer Platine befestigt ist, von dem beispielsweise aus Metall oder Gusseisen hergestellten Kühlkörper umgeben, beispielsweise indem die Spule in eine Kuhle des Kühlkörpers beim Befestigen eintaucht. Der Kühlkörper wird so nicht nur zur Kühlung, sondern gleichzeitig als Schirmblech verwendet.

Ein weiterer Vorteil ergibt sich dadurch, dass OLEDs hierdurch auch innerhalb eines bei Bordnetzen von Kraftfahrzeugen nicht unüblichen Spannungsbereichs von 7V bis 17V betrieben werden können, da der kritische Spannungsbereich bei Temperaturen unter 0°C vermittels der Beheizung umgangen werden kann.

Einen anderen Vorteil stellt die Kühlung dar, mittels der verhindert werden kann, dass die OLED eine Temperaturgrenze überschreitet, bei welcher ihre Lebensdauer rapide abnimmt.

Das vorzugsweise elektrische Temperierelement kann unmittelbar auf der OLED, beispielsweise auf einem vorder- oder rückseitigen Glasplättchen oder Kunststoffplättchen der OLED angeordnet sein.

Alternativ oder zusätzlich kann zumindest ein Temperatursensor unmittelbar auf der OLED, beispielsweise auf einem vorder- oder rückseitigen Glasplättchen der OLED angeordnet sein.

Eine vorteilhafte Ausgestaltung ergibt sich, wenn das Leuchtmittel zusätzlich einen Träger umfasst, an dem die mindestens eine OLED des Leuchtmittels angeordnet ist, beispielsweise indem der Träger die mindestens eine OLED des Leuchtmittels trägt oder hält.

Damit einhergehende Vorteile sind die Vermeidung von Schäden, die wegen des Aufbaus von OLEDs mit eine Vorder- bzw. Rückseite der OLED bildenden Deck- und Rückflächen aus jeweils dünnen Glasplättchen beim Einsatz in Kraftfahrzeugleuchten auftreten würden, wenn OLEDs nicht frei von mechanischen Spannungen untergebracht werden können, und der Erhalt einer Kühlung bzw. Abfuhr der beim Betrieb von OLEDs entstehenden Wärme, die für den tatsächlichen Gebrauch von OLEDs, die sehr temperaturempfindlich sind, in Kraftfahrzeugleuchten erforderlich ist.

Die Erfindung ermöglicht dadurch, OLEDs unter den im Betrieb von Kraftfahrzeugleuchten auftretenden mechanischen und thermischen Belastungen einzusetzen und damit für den tatsächlichen Gebrauch in Kraftfahrzeugen vorzusehen.

Das elektrische Temperierelement kann auf oder in dem mit der mindestens einen OLED verbundenen Träger angeordnet sein. Beispielsweise kann das elektrische Temperierelement zwischen OLED und dem Träger und/oder auf einer der mindestens einen OLED abgewandten Seite des Trägers angeordnet sein.

Die mindestens eine OLED kann mindestens einen Bereich mit wenigstens einer bei deren Betrieb leuchtenden Fläche mit Abstrahlung von Licht in einer Richtung und/oder mindestens einen Bereich mit wenigstens einer bei deren Betrieb leuchtenden Fläche mit Abstrahlung von Licht in zwei, beispielsweise entgegengesetzten Richtungen und/oder mindestens einen Bereich mit wenigstens einer Fläche, die transparent ist und nicht leuchtet und/oder mindestens einen Bereich mit wenigstens einer Fläche, die weder transparent ist, noch leuchtet aufweisen.

Eine Richtung, in welcher dabei bei Betrieb der mindestens einen OLED eine Abstrahlung von Licht erfolgt ist dabei durch einen Kegel mit einem Öffnungswinkel von 0° bis 90° definiert, dessen Kegelachse normal auf der jeweiligen Fläche aufsteht. Vereinfacht betrachtet ist die Richtung, in welcher eine Abstrahlung erfolgt, durch die Flächennormale der jeweiligen Fläche gegeben.

Der Träger kann auf einer Rückseite und/oder einer Vorderseite der mindestens einen OLED angeordnet sein, beispielsweise in einem Bereich, in welchem die mindestens eine OLED eine leuchtende Fläche mit Abstrahlung in nur einer Richtung aufweist, wobei der Träger bevorzugt auf derjenigen Seite der mindestens einen OLED vorgesehen ist, in welcher Richtung keine Abstrahlung erfolgt, und/oder in einem Bereich, in welchem die mindestens eine OLED eine Fläche aufweist, die nicht abstrahlend ist und entweder transparent oder nicht transparent ist.

Sich hierdurch ergebende Vorteile sind eine einwandfreie spannungsfreie Halterung von OLEDs auf dem Träger, ohne deren Lichtabstrahlung wesentlich zu behindern, einhergehend mit einer thermischen Ankopplung, um beim Betrieb der OLED entstehende Wärme optimal abführen zu können.

Der Träger kann selbst aus einem transparenten Werkstoff hergestellt sein, beispielsweise PMMA (PMMA: Polymethylmethacrylat). Dadurch kann der Träger auch in einem oder mehreren Bereichen mit einer leuchtende Fläche mit Abstrahlung in zwei Richtungen angeordnet sein und/oder auf derjenigen Seite eines oder mehrerer Bereiche mit einer leuchtende Fläche mit Abstrahlung in einer Richtung, in welcher Richtung die Abstrahlung erfolgt.

Der Träger kann in einem oder mehreren Bereichen der mindestens einen OLED ausgespart sein, beispielsweise in einem oder mehreren Bereichen mit mindestens einer leuchtenden Fläche mit Abstrahlung in einer Richtung und/oder mit mindestens einer leuchtenden Fläche mit Abstrahlung in zwei Richtungen und/oder mindestens einer Fläche, die transparent und nicht abstrahlend ist.

Der Träger kann mit einer totalreflektierenden (TIR: Total Internal Reflection) Struktur und/oder beispielsweise verspiegelten Prismen versehen sein. Alternativ oder zusätzlich können derartige TIR-Strukturen und/oder Prismen auf einem oder mehreren Bereichen zumindest einer OLED vorgesehen sein. Licht, welches beispielsweise von einer anderen Lichtquelle, als einer OLED des Leuchtmittels kommend oder seitlich aus einer OLED des Leuchtmittels austretend auf die Prismen und/oder einer TIR-Struktur trifft kann durch diese in eine Richtung umgelenkt werden, in welcher es der Erfüllung einer Lichtverteilung beispielsweise einer Lichtfunktion einer Kraftfahrzeugleuchte beiträgt oder zumindest beitragen kann.

Darüber hinaus kann eine der OLED abgewandte Seite des Trägers mit Prismen und/oder einer TIR-Struktur versehen sein, welche Licht, welches beispielsweise von einer anderen Lichtquelle, als der OLED des Leuchtmittels kommend oder seitlich aus der OLED des Leuchtmittels austretend auf die Prismen und/oder einer TIR-Struktur trifft, in eine Richtung umlenken, in welcher es der Erfüllung einer Lichtverteilung beispielsweise einer Lichtfunktion einer Kraftfahrzeugleuchte beiträgt oder zumindest beitragen kann.

Die OLED weist bevorzugt mindestens eine leuchtende Fläche mit Abstrahlung in einer Richtung auf. Der Träger weist vorzugsweise eine mit mindestens einer leuchtenden Fläche mit Abstrahlung in einer Richtung der OLED in ihrer Geometrie und in ihren Abmessungen identische Befestigungsfläche auf, auf welche die OLED mit ihrer Rückseite aufgeklebt wird. Die Rückseite bildet dabei diejenige Oberfläche der OLED, die der Richtung abgewandt ist, in welche gesehen die leuchtende Fläche mit Abstrahlung in einer Richtung der OLED abstrahlt. Hierdurch erfolgt eine besonders effektive Abfuhr insbesondere der in der leuchtenden Fläche mit Abstrahlung in einer Richtung beim Betrieb der OLED entstehenden Wärme, ohne dass der Gesamteindruck einer eine leuchtende Fläche bildende OLED durch überstehende, störende und nicht leuchtende Flächen beeinträchtigt wird.

Die Erfindung löst damit die dem Erhalt sowohl einer größtmöglichen optischen Güte, als auch zum notwendigen Walten von Sorgfalt beim Umgang mit OLEDs entgegenstehenden Probleme einer bestmöglichen thermischen Ankopplung der OLED und deren spannungsfreier Befestigung gleichzeitig und gleichermaßen durch einen Träger, auf den eine OLED beispielsweise durch Aufkleben spannungsfrei befestigt wird, und welcher Träger im Leuchteninnenraum befestigt werden kann.

Der Träger kann an zumindest einer - vorzugsweise an genau einer - seiner Schmalseiten Befestigungsmittel aufweisen, mit denen er beispielsweise in einen von einem Leuchtengehäuse und einer Lichtscheibe umschlossenen Leuchteninnenraum einer Kraftfahrzeugleuchte kragend befestigt werden kann. Dadurch ist sichergestellt, dass sowohl bei der Montage, als auch während des Einsatzes im Kraftfahrzeug die OLED spannungsfrei gehalten wird.

Die Befestigungsmittel können mindestens eine Anschlagfläche und wenigstens einen Schraubdom umfassen. Der Träger mitsamt der darauf angeordneten OLED kann dadurch von der Rückseite beispielsweise einer in einem Leuchteninnenraum einer Kraftfahrzeugleuchte untergebrachten Blende durch diese hindurchgesteckt und rückseitig mittels eines oder mehrerer Schraubdome verschraubt sein.

Alternativ kann beispielsweise bei Anordnung mehrerer Träger in einem Leuchteninnenraum oder in einer von mehreren einen Leuchteninnenraum unterteilenden Leuchtenkammern und/oder bei einer stark geneigten Anordnung gegenüber der Blende, wenn kein Bauraum für einen rückseitigen Schraubdom sowie für das Einbringen des Trägers von der Rückseite der Blende her vorhanden ist, eine Anordnung des Trägers von der Vorderseite der Blende her vorgesehen sein. Zur Befestigung des Trägers an der Blende sehen die Befestigungsmittel eine durch die Blende hindurchreichende Partie des Trägers sowie eine auf der Rückseite der Blende abstehende Auskragung und mindestens eine auf der dem Träger abgewandten Rückseite der Blende parallel zur Blende angeordnete Klammer vor, wobei die durch die Blende hindurchreichende Partie des Trägers sowie die auf der Rückseite der Blende abstehenden Auskragung einander zugewandte, korrespondierende Führungsflächen aufweisen. Die Klammer umgreift die durch die Blende hindurchreichende Partie des Trägers sowie die auf der Rückseite der Blende abstehende Auskragung und presst die einander zugewandte Führungsflächen der durch die Blende hindurchreichende Partie des Trägers sowie der auf der Rückseite der Blende abstehenden Auskragung aneinander. Hierdurch erfolgt sowohl die Befestigung des Trägers, als auch dessen vibrationssichere Halterung an der Blende.

Die Partie und/oder die Auskragung können eine Kerbe zur Aufnahme der Klammer aufweisen.

Um ein Verkippen des Trägers zu vermeiden, bei welchem Verkippen die Führungsfläche des Trägers auf der der Blende abgewandte Seite der durch die Blende hindurchreichenden Partie des Trägers von der Führungsfläche der Auskragung abheben würde, können die Befestigungsmittel darüber hinaus eine normal auf einer durch die Blende im Bereich deren Durchdringung durch die Partie gebildeten Fläche aufstehende Klammer vorsehen, welche die Auskragung und die Partie von der der Blende abgewandten Seite her umgreift.

Der Träger kann als ein Spritzgussteil hergestellt sein.

Der Träger kann aus einem transparenten Material hergestellt sein, wodurch ein frei schwebender Eindruck der Leuchtfläche der OLED sowohl in ausgeschaltetem Zustand, als auch während deren Betriebs im Leuchteninnenraum entsteht. Durch die Verwendung transparenten Materials kann die optische Güte des Leuchtmittels nochmals gesteigert werden, da weniger Lichtleistung verloren geht, da in Richtung des Trägers von der OLED abgestrahltes Licht von dem transparenten Träger nicht oder nur wenig absorbiert wird, und stattdessen einem Beitrag zu einer Lichtverteilung einer Leichtfunktion beispielsweise einer Kraftfahrzeugleuchte zugeführt werden kann.

Denkbar ist auch, dass der Träger beispielsweise im Bereich wenigstens einer leuchtenden Fläche mit Abstrahlung in zwei Richtungen mit Prismen und/oder einer TIR-Struktur halbtransparent ausgeführt ist, wobei in Richtung des Trägers abgestrahltes Licht der OLED umgelenkt bzw. reflektiert wird und beispielsweise wieder durch die OLED hindurch gestrahlt wird. Die OLED-Vorderseite strahlt dann ohne Einfluss des Trägers ab und die Abstrahlung der OLED-Rückseite wird durch die Optik in Form von Prismen und/oder einer TIR-Struktur an dem Träger beeinflusst.

Der Träger und/oder die Rückseite der OLED können im Bereich wenigstens einer Fläche mit Abstrahlung in einer Richtungen und/oder metallisiert bzw. verspiegelt sein, oder der Träger kann alternativ oder zusätzlich aus einem Metall hergestellt sein.

Eine reflektierende Ausführung des Trägers kann demnach durch Verwendung eines transparenten, klaren Materials für den Träger in Verbindung mit totalreflektierenden Optiken auf dessen Rückseite verwirklicht sein, und/oder durch eine spiegelnde und reflektierende Beschichtung.

Wichtig ist hervorzuheben, dass der Träger eine beispielsweise zentrale Lichtöffnung aufweisen kann, welche von einer Fläche mit Abstrahlung von Licht in einer oder in zwei, beispielsweise entgegengesetzten Richtungen, der OLED abgedeckt sein kann.

Alternativ oder zusätzlich kann der Träger eine zentrale Lichtöffnung beispielsweise für von einer beim Blick durch eine Lichtscheibe einer Kraftfahrzeugleuchte hindurch gesehen hinter dem Träger angeordneten Lichtquelle abgestrahltes Licht aufweisen. Eine solche Lichtquelle kann beispielsweise für eine andere Lichtfunktion vorgesehen sein, als die auf dem Träger angeordnete mindestens eine OLED.

Ein zweiter Gegenstand der Erfindung betrifft eine Kraftfahrzeugleuchte mit wenigstens einem zur Erfüllung wenigstens einer Lichtfunktion der Kraftfahrzeugleuchte vorgesehenen, zuvor beschriebenen Leuchtmittel.

Die mindestens eine OLED nebst dem wenigstens einen zumindest in wärmeleitendem Kontakt mit der OLED stehenden Temperierelement kann in eine Lichtscheibe und/oder eine Rückwand und/oder in ein anderes Bauteil der Kraftfahrzeugleuchte integriert sein.

Die Kraftfahrzeugleuchte kann einen von einer Lichtscheibe und einem Leuchtengehäuse zumindest zum Teil umschlossenen Leuchteninnenraum aufweisen, in dem ein Leuchtmittel beherbergt sein kann.

Die Kraftfahrzeugleuchte kann mehrere beim Blick von außerhalb des Leuchteninnenraums durch die Lichtscheibe hindurch gesehen räumlich neben- und/oder hintereinander angeordnete, zuvor beschriebene Leuchtmittel mit jeweils einem Träger und wenigstens einer an dem Träger angeordneten bzw. von dem Träger im Leuchteninnenraum gehaltenen OLED als Lichtquelle aufweisen.

Alternativ oder zusätzlich kann die Kraftfahrzeugleuchte mindestens ein zuvor beschriebenes Leuchtmittel mit einem Träger und wenigstens einer an dem Träger angeordneten bzw. von dem Träger im Leuchteninnenraum gehaltenen OLED als Lichtquelle aufweisen, sowie mindestens ein zusätzliches in dem Leuchteninnenraum beherbergtes und zur Erfüllung zumindest der selben oder einer weiteren Lichtfunktion der Kraftfahrzeugleuchte vorgesehenes Leuchtmittel mit wenigstens einer Lichtquelle.

Zumindest eine Lichtquelle eines zur Erfüllung zumindest der selben oder einer weiteren Lichtfunktion der Kraftfahrzeugleuchte vorgesehenen, zusätzlichen Leuchtmittels kann beim Blick von außerhalb des Leuchteninnenraums durch die Lichtscheibe hindurch gesehen hinter der mindestens einen von dem Träger im Leuchteninnenraum gehaltenen OLED angeordnet sein, so dass wenigstens eine OLED im direkten Strahlengang des von der zumindest einen Lichtquelle des zur Erfüllung zumindest der selben oder einer weiteren Lichtfunktion der Kraftfahrzeugleuchte vorgesehenen, zusätzlichen Leuchtmittels zur Lichtscheibe liegt.

Der mindestens eine OLED im Leuchteninnenraum haltende Träger kann eine beispielsweise zentrale Lichtöffnung beispielsweise für von einer beim Blick durch eine Lichtscheibe einer Kraftfahrzeugleuchte hindurch gesehen hinter dem Träger angeordneten Lichtquelle eines zur Erfüllung zumindest der selben oder einer weiteren Lichtfunktion der Kraftfahrzeugleuchte vorgesehenen, zusätzlichen, beispielsweise mit einem zuvor beschriebenen Leuchtmittel mit einem Träger und mindestens einer von diesem gehaltenen OLED identischen Leuchtmittels abgestrahltes Licht aufweisen.

Durch das Unterbringen mehrerer OLEDs in einer Kraftfahrzeugleuchte kommt es zu gegenseitigen Abschattungen deren leuchtender Flächen, was zur Folge hat, das einzelne Winkelbereiche eine zu geringe Lichtstärke aufweisen in Bezug auf die beispielsweise gesetzlich geforderten, von einer Lichtverteilung vorgegebenen Lichtwerte. Durch beispielsweise zentrale Lichtöffnungen zumindest in den Trägern der vorderen, der Lichtscheibe näheren Leuchtmitteln mehrerer beim Blick von außerhalb des Leuchteninnenraums durch die Lichtscheibe hindurch gesehen räumlich neben- und/oder hintereinander angeordneter, zuvor beschriebener Leuchtmittel mit jeweils einem Träger und wenigstens einer an dem Träger angeordneten bzw. von dem Träger im Leuchteninnenraum gehaltenen OLED als Lichtquelle kann dieser gegenseitigen Abschattung zur Erhöhung der Lichtwerte in einzelnen Winkelbereichen entgegengewirkt werden.

Eine gegebenenfalls in einem Träger wenigstens eines von mehreren Leuchtmitteln vorgesehene zentrale Lichtöffnung kann zumindest zum Teil von einer leuchtenden Fläche einer OLED mit Abstrahlung in zwei Richtungen und/oder einer Fläche einer OLED, die transparent und nicht abstrahlend ist abgedeckt sein. Eine derartig abgedeckte, beispielsweise zentrale Lichtöffnung kann einer Abschattung einer dahinterliegenden OLED oder einer anderen, dahinterliegenden Lichtquelle des selben oder eines anderen Leuchtmittels entgegenwirken und bildet so ein transparentes OLED-Fenster, das auch leuchten kann.

Zumindest zwei von mindestens zwei Lichtfunktionen der Kraftfahrzeugleuchte können unterschiedliche Lichtfarben aufweisen.

Die Kraftfahrzeugleuchte kann einen von einem Leuchtengehäuse und einer Lichtscheibe umschlossenen Leuchteninnenraum aufweisen, in dem mindestens eine Blende untergebracht sein kann, durch welche hindurch der Träger des Leuchtmittels hindurchgesteckt bzw. an welcher der Träger des Leuchtmittels befestigt sein kann.

Die Kraftfahrzeugleuchte kann einen von einem Leuchtengehäuse und einer Lichtscheibe umschlossenen Leuchteninnenraum aufweisen, in dem mindestens ein weiteres Leuchtmittel zur Erfüllung zumindest einer weiteren Lichtfunktion der Kraftfahrzeugleuchte angeordnet sein kann. Zumindest zwei der dann vorgesehenen mindestens zwei Lichtfunktionen der Kraftfahrzeugleuchte können unterschiedliche Lichtfarben aufweisen.

Die Kraftfahrzeugleuchte ist bevorzugt als Heckleuchte ausgeführt. Alternativ kann die Kraftfahrzeugleuchte als in einem Außenrückblickspiegel untergebrachte Wiederholblinkleuchte ausgestaltet sein.

Wichtig ist hervorzuheben, dass die Kraftfahrzeugleuchte zusätzlich zu der durch die mindestens eine OLED zu erfüllenden Lichtfunktion über mindestens eine konventionell vermittels beispielsweise eines oder mehrerer beispielsweise in einer separaten Reflektorkammer untergebrachten Leuchtmittels und/oder eines Lichtleiters verwirklichte, zusätzliche Lichtfunktion verfügen kann. Bei dieser mindestens einen zusätzlichen Lichtfunktion kann es sich beispielsweise um eine solche Lichtfunktion handeln, deren Lichtwerte und/oder deren gesetzliche Vorschriften vermittels einer flächigen Lichtquelle wie einer OLED nur unter hohem Aufwand zu erfüllen sind.

Alternativ oder zusätzlich können eine oder mehrere Lichtfunktionen unabhängig von der Kraftfahrzeugleuchte untergebracht sein. Beispielsweise können eine der Erfüllung einer Nebelschlusslichtfunktion dienende Nebelschlussleuchte und/oder ein der Erfüllung einer Rückfahrlichtfunktion dienender Rückfahrscheinwerfer zusammen in einem Modul der Kraftfahrzeugleuchte örtlich ausgelagert sein, während sich in einem anderen Bereich der Kraftfahrzeugleuchte die verbleibenden Lichtfunktionen konzentrieren. Ein Grund hierfür kann beispielsweise sein, dass die Nebelschlusslichtfunktion einen Mindestabstand zum Bremslichtfunktion aufgrund gesetzlicher Vorgaben einhalten muss. Durch diese Abtrennung ist dann zusätzlich eine größere Gestaltungsfreiheit gegeben.

Die Kraftfahrzeugleuchte erlaubt die beschriebenen Vorteile des Leuchtmittels im Kraftfahrzeug- bzw. Automobilbereich zu nutzen.

Die Erfindung stellt damit eine Möglichkeit dar, OLEDs in Kraftfahrzeugleuchten nahezu vollständig mechanisch spannungsfrei aufzunehmen. Gleichzeitig können mit der Erfindung die Anforderungen an mechanische und thermische Stabilität beispielsweise nach dem Standard LV 124 vollständig erfüllt werden. Weiterhin erlaubt die Erfindung die OLED vermittels eines Trägers passiv gleichmäßig zu temperieren, da Kunststoff gegebenenfalls zuzüglich eines zwischen Träger und OLED zu deren Befestigung angeordneten Klebebands oder Klebers auf der Rückseite der OLED Wärme besser leitet als Luft. Darüber hinaus erlaubt die Erfindung vor allem die OLED aktiv zu temperieren. Für die aktive Temperierung wird die Temperatur an der OLED und/oder in der Kraftfahrzeugleuchte - mittels mindestens eines allgemein als Temperatursensor bezeichneten Temperaturfühlers in Form eines elektrischen Bauteils oder einer Schaltung an und/oder in der Nähe der OLED erfasst und/oder durch Änderung der Spannung an der OLED ermittelt. Zumindest in wärmeleitender Verbindung mit der mindestens einen OLED des Leuchtmittels, beispielsweise an dem Träger, ist ein aktives, elektrisches Temperierelement angebracht. Dieses kann die OLED nach Bedarf erwärmen und/oder kühlen und so die I-U-Kennlinie der OLED einschließlich des elektrischen Arbeitspunkts für deren Betrieb in einem begrenzten, vorgegebenen Temperaturbereich halten.

Die Erfindung wird nachfolgend anhand von in den Zeichnungen dargestellter Ausführungsbeispiele näher erläutert. Darin bezeichnen gleiche Bezugszeichen gleiche oder gleich wirkende Elemente. Der Übersicht halber sind nur Bezugszeichen in den einzelnen Zeichnungen dargestellt, die für die Beschreibung der jeweiligen Zeichnung erforderlich sind. Die Größenverhältnisse der einzelnen Elemente zueinander entsprechen dabei nicht immer den realen Größenverhältnissen, da einige Formen vereinfacht und andere Formen zur besseren Veranschaulichung vergrößert im Verhältnis zu anderen Elementen dargestellt sind. Es zeigen in schematischer Darstellung:

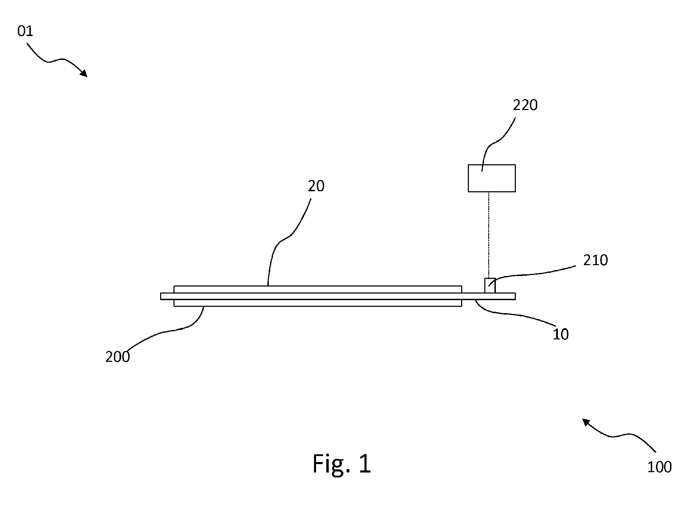

- Fig. 1: ein Leuchtmittel mit mindestens einer OLED als Lichtquelle und mit mindestens einem mit wenigstens einer OLED des Leuchtmittels in zumindest wärmeleitendem Kontakt stehenden, vorzugsweise elektrischen Temperierelement in einem Querschnitt.

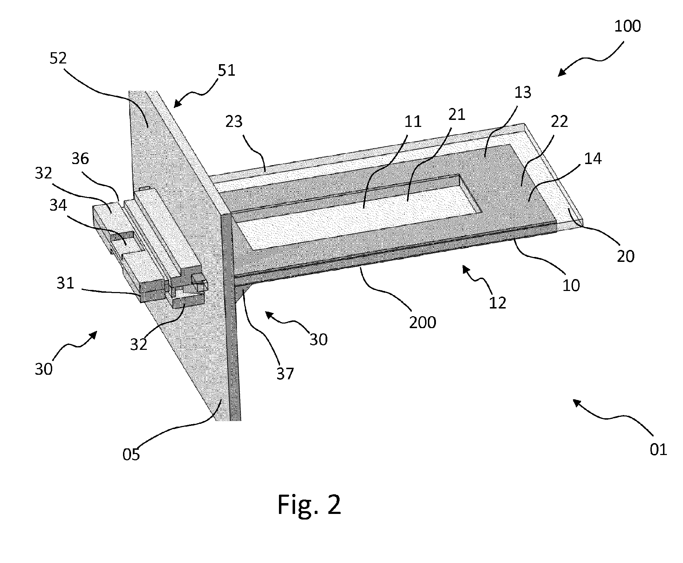

- Fig. 2: ein Leuchtmittel mit mindestens einer OLED als Lichtquelle und mit mindestens einem mit wenigstens einer OLED des Leuchtmittels in zumindest wärmeleitendem Kontakt stehenden, vorzugsweise elektrischen Temperierelement, welches mit einem die mindestens eine OLED und das mit ihr in zumindest wärmeleitendem Kontakt stehende Temperierelement haltenden Träger gemäß eines ersten Ausführungsbeispiels ausgestattet ist, der durch eine Blende hindurchragt, mit einem ersten Teil dessen Befestigungsmittel auf der der OLED zugewandten Vorderseite der Blende und mit einem ersten, unvollständigen zweiten Teil dessen Befestigungsmittel auf der der OLED abgewandten Rückseite der Blende in einer perspektivischen Ansicht schräg von hinter der Blende aus gesehen mit Blick auf die Vorderseite der OLED.

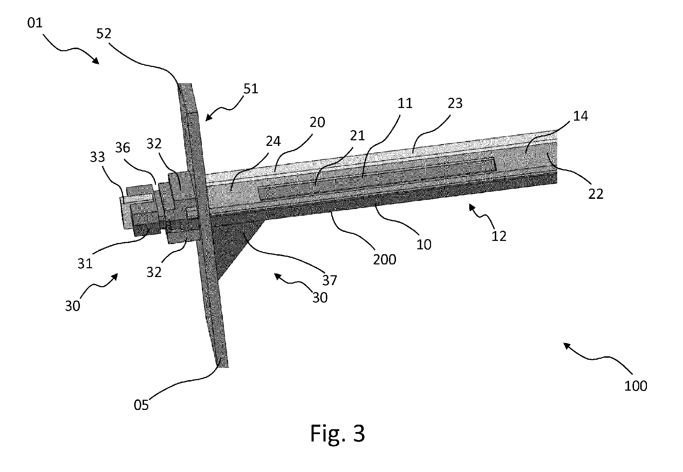

- Fig. 3: das Leuchtmittel aus Fig. 2, dessen Träger durch eine Blende hindurchragt, mit gegenüber dem ersten, unvollständigen zweiten Teil der Befestigungsmittel in Fig. 2 weiter komplettiertem zweitem, unvollständigem zweitem Teil der Befestigungsmittel in einer perspektivischen Ansicht von hinter der Blende aus gesehen mit Blick auf die Vorderseite der OLED.

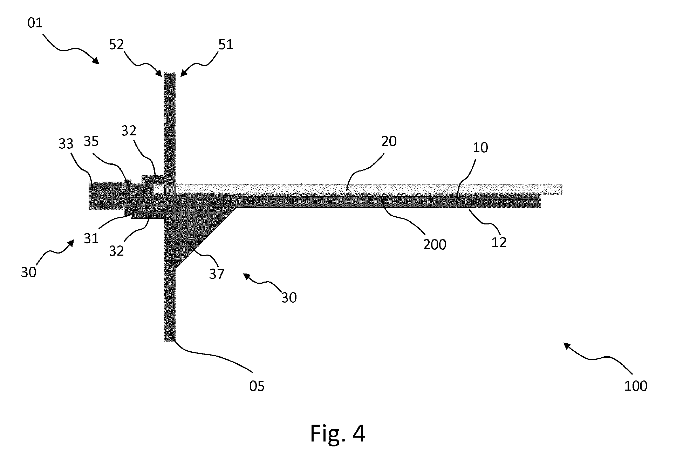

- Fig. 4: das Leuchtmittel aus Fig. 2, dessen Träger durch eine Blende hindurchragt, mit dem ersten Teil dessen Befestigungsmittel und einem gegenüber dem zweiten, unvollständigen zweiten Teil dessen Befestigungsmittel aus Fig. 3 weiter komplettierten dritten, nunmehr vollständigen zweiten Teil dessen Befestigungsmittel in einer Seitenansicht.

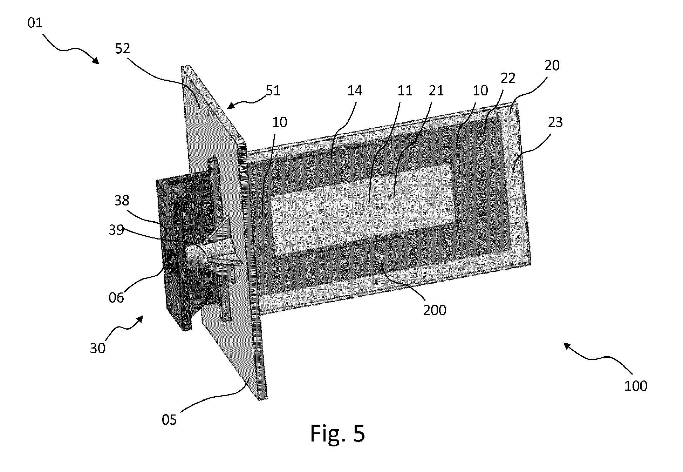

- Fig. 5: ein Leuchtmittel mit mindestens einer OLED als Lichtquelle und mit mindestens einem mit wenigstens einer OLED des Leuchtmittels in zumindest wärmeleitendem Kontakt stehenden, vorzugsweise elektrischen Temperierelement, welches mit einem die mindestens eine OLED und das mit ihr in zumindest wärmeleitendem Kontakt stehende Temperierelement haltenden Träger gemäß eines zweiten Ausführungsbeispiels ausgestattet ist, der durch eine Blende hindurchragt, nebst dessen Befestigungsmitteln in einer perspektivischen Ansicht von hinter der Blende aus gesehen mit Blick auf die Vorderseite der OLED.

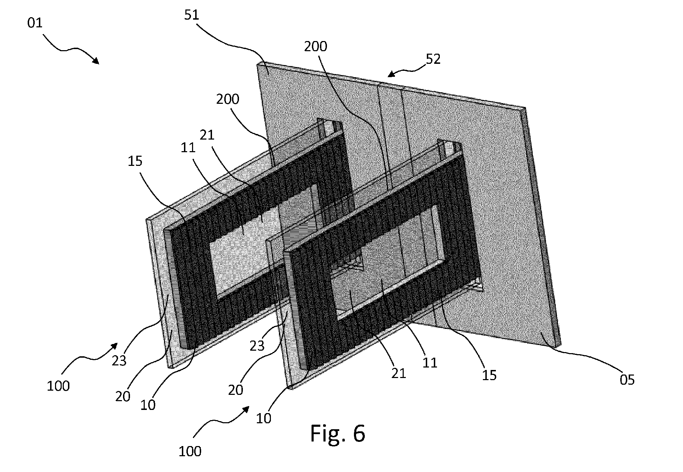

- Fig. 6: eine Anordnung zweier Leuchtmittel mit jeweils mindestens einer OLED als Lichtquelle und mit jeweils mindestens einem mit wenigstens einer OLED jeden Leuchtmittels in zumindest wärmeleitendem Kontakt stehenden, vorzugsweise elektrischen Temperierelement, welche jeweils mit einem die mindestens eine OLED und das mit ihr in zumindest wärmeleitendem Kontakt stehende Temperierelement haltenden Träger gemäß eines dritten Ausführungsbeispiels ausgestattet sind, die jeweils durch eine Blende hindurchragen, in einer perspektivischen Ansicht schräg von hinten mit Blick auf die Rückseiten der OLEDs.

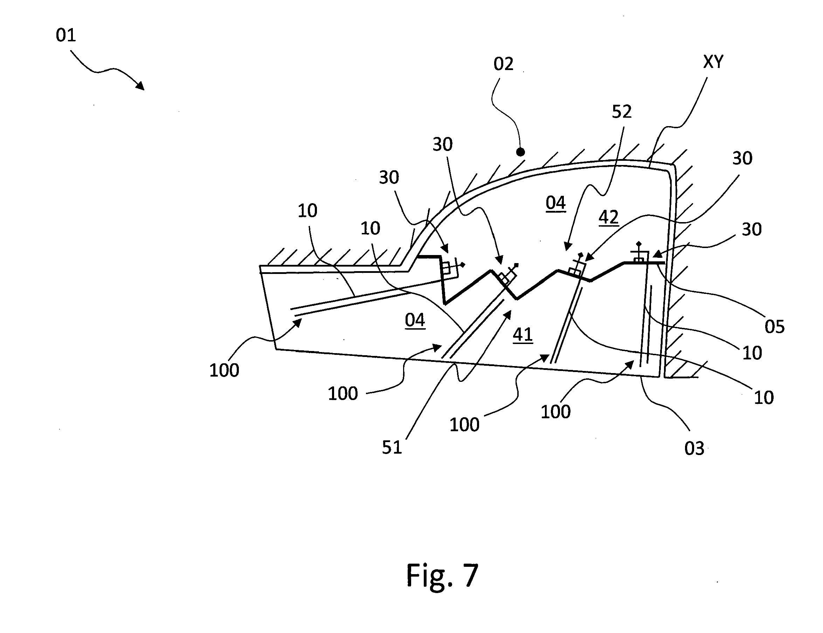

- Fig. 7: eine Kraftfahrzeugleuchte mit einem von einem Leuchtengehäuse und einer Lichtscheibe zumindest zum Teil umschlossenen Leuchteninnenraum mit einer darin beherbergten Blende, welche den Leuchteninnenraum in einen durch die Lichtscheibe hindurch gesehen vor der Blende liegenden und durch die Lichtscheibe hindurch einsehbaren, ersten Bereich und in einen durch die Lichtscheibe hindurch gesehen hinter der Blende liegenden und durch die Lichtscheibe hindurch nicht einsehbaren, zweiten Bereich einteilt, mit einer Mehrfachanordnung mehrerer Leuchtmittel mit jeweils mindestens einer OLED als Lichtquelle und mit jeweils mindestens einem mit wenigstens einer OLED jeden Leuchtmittels in zumindest wärmeleitendem Kontakt stehenden, vorzugsweise elektrischen Temperierelement, welche jeweils mit einem die mindestens eine OLED und das mit ihr in zumindest wärmeleitendem Kontakt stehende Temperierelement haltenden Träger ausgestattet sind, deren Träger vom zweiten Bereich aus in den ersten Bereich hinein durch die Blende hindurchragen, in einem Querschnitt.

Eine in Fig. 1 bis Fig. 7 ganz oder in Teilen dargestellte, beispielsweise als Heckleuchte ausgeführte Kraftfahrzeugleuchte 01 weist einen von einem Leuchtengehäuse 02 und mindestens einer Lichtscheibe 03 zumindest zum Teil umschlossenen Leuchteninnenraum 04 auf.

In dem Leuchteninnenraum 04 ist wenigstens ein zur Erfüllung wenigstens einer Lichtfunktion der Kraftfahrzeugleuchte 01 vorgesehenes Leuchtmittel 100 beherbergt.

Der von dem Leuchtengehäuse 02 und zumindest einer Lichtscheibe 03 zumindest zum Teil umschlossene Leuchteninnenraum 04 der Kraftfahrzeugleuchte 01 beherbergt vorzugsweise eine Blende 05.

Die Blende 05 teilt den Leuchteninnenraum 04 in einen durch die Lichtscheibe 03 hindurch gesehen vor der Blende 05 liegenden und durch die Lichtscheibe 03 hindurch einsehbaren, ersten Bereich 41 und in einen durch die Lichtscheibe 03 hindurch gesehen hinter der Blende 05 liegenden und durch die Lichtscheibe 03 hindurch nicht einsehbaren, zweiten Bereich 42 ein.

Die Kraftfahrzeugleuchte 01 umfasst mindestens ein zur Erfüllung wenigstens einer Lichtfunktion der Kraftfahrzeugleuchte 01 vorgesehenes Leuchtmittel 100 mit zumindest einer OLED 20 als Lichtquelle.

Die Kraftfahrzeugleuchte 01 zeichnet sich dadurch aus, dass wenigstens ein Leuchtmittel 100 mit mindestens eine OLED 20 als Lichtquelle mindestens ein mit wenigstens einer OLED 20 des Leuchtmittels 100 in zumindest wärmeleitendem Kontakt stehendes Temperierelement 200 aufweist.

Mindestens ein Temperierelement 200 ist dabei bevorzugt elektrisch betrieben.

Das mindestens eine Temperierelement 200 kann mindestens ein Heizelement und/oder mindestens ein Kühlelement umfassen.

Als Heizelement kommen beispielsweise eine oder mehrere elektrische Heizwendeln in Frage.

Als Kühlelement kommen beispielsweise ein oder mehrere Peltier-Elemente in Frage, wobei grundsätzlich sowohl der Thomson-Effekt als auch der Peltier-Effekt genutzt werden können, um die OLED zu kühlen.

Das Leuchtmittel 100 kann darüber hinaus einen mit wenigstens einer OLED 20 des Leuchtmittels 100 in zumindest wärmeleitendem Kontakt stehenden Temperaturfühler bzw. Temperatursensor 210 aufweisen. Der Temperatursensor 210 erzeugt ein einer von ihm erfassen Temperatur, beispielsweise einer Umgebungstemperatur der mindestens einen OLED 20 des Leuchtmittels 100 oder der Temperatur mindestens einer OLED 20 des Leuchtmittels 100 proportionales Ausgangssignal.

Das Leuchtmittel 100 kann einen mit dem Temperatursensor 210 verbundenen Schaltkreis 220 aufweisen, der vom Ausgangssignal des Temperatursensors 210 gesteuert wird, und mit dem Temperierelement 200 verbunden ist und dessen Betrieb und/oder Stromzufuhr steuert, um auf die Temperatur mindestens einer OLED 20 des Leuchtmittels 100 Einfluss zu nehmen.

Der Schaltkreis 220 kann einen Schalter umfassen, welcher bei einem einer von dem Temperatursensor 210 erfassten Temperatur, die kleiner ist, als eine vorgegebene Schwellentemperatur von beispielsweise 0°C proportionalen Ausgangssignal von dem Temperatursensor 210 derart geschaltet wird, dass ein vom Temperierelement 200 umfasstes Heizelement dann bestromt und dadurch betrieben wird und hiermit die mindestens eine mit dem Temperierelement 200 zumindest in wärmeleitendem Kontakt stehende OLED 20 beheizt wird, und welcher bei einem einer von dem Temperatursensor 210 erfassten Temperatur, die größer ist, als eine vorgegebene Schwellentemperatur von beispielsweise 0°C proportionalen Ausgangssignal von dem Temperatursensor 210 derart geschaltet wird, dass das vom Temperierelement 200 umfasste Heizelement dann nicht bestromt und dadurch auch nicht betrieben wird und hiermit die mindestens eine mit dem Temperierelement 200 zumindest in wärmeleitendem Kontakt stehende OLED 20 nicht beheizt wird.

Der Schaltkreis 220 kann alternativ oder zusätzlich einen Proportionalregler umfassen, der ein vom Temperierelement 200 umfasstes Heizelement unterhalb einer vorgegebenen Schwellentemperatur um so höher bestromt und dadurch um so stärker betreibt, je niedriger die vom Temperatursensor 210 erfasste Temperatur ist, und dadurch die Heizwirkung des Temperierelements 200 steigert, je niedriger die vom Temperatursensor 210 erfasste Temperatur ist.

Der Schaltkreis 220 kann eine Kombination aus einem oder mehreren Schaltern und einem oder mehreren Proportionalreglen umfassen, wobei der Schalter eine generelle Stromunterbrechung für das vom vorzugsweise elektrischen Temperierelement 200 umfasste Heizelement bei einem einer von dem Temperatursensor 210 erfassten Temperatur, die größer ist, als eine vorgegebene Schwellentemperatur von beispielsweise 0°C proportionalen Ausgangssignal besorgt, und der Proportionalregler eine mit einem einer abnehmenden, von dem Temperatursensor 210 erfassten Temperatur, die kleiner ist, als eine vorgegebene Schwellentemperatur von beispielsweise 0°C proportionalen Ausgangssignal zunehmende Bestromung des vom vorzugsweise elektrischen Temperierelement 200 umfassten Heizelements besorgt.

Alternativ oder zusätzlich kann der Schaltkreis 220 einen Schalter umfassen, welcher bei einem einer von dem Temperatursensor 210 erfassten Temperatur, die größer ist, als eine vorgegebene Schwellentemperatur von beispielsweise 80°C proportionalen Ausgangssignal von dem Temperatursensor 210 derart geschaltet wird, dass ein vom Temperierelement 200 umfasstes Kühlelement dann bestromt und dadurch betrieben wird und hiermit die mindestens eine mit dem Temperierelement 200 zumindest in wärmeleitendem Kontakt stehende OLED 20 gekühlt wird, und welcher bei einem einer von dem Temperatursensor 210 erfassten Temperatur, die kleiner ist, als eine vorgegebene Schwellentemperatur von beispielsweise 80 °C proportionalen Ausgangssignal von dem Temperatursensor 210 derart geschaltet wird, dass das vom Temperierelement 200 umfasste Kühlelement dann nicht bestromt und dadurch auch nicht betrieben wird und hiermit die mindestens eine mit dem Temperierelement 200 zumindest in wärmeleitendem Kontakt stehende OLED 20 nicht gekühlt wird.

Der Schaltkreis 220 kann alternativ oder zusätzlich einen Proportionalregler umfassen, der ein vom Temperierelement 200 umfasstes Kühlelement oberhalb einer vorgegebenen Schwellentemperatur um so höher bestromt und dadurch um so stärker betreibt, je höher die vom Temperatursensor 210 erfasste Temperatur ist, und dadurch die Kühlwirkung des Temperierelements 200 steigert, je höher die vom Temperatursensor 210 erfasste Temperatur ist.

Der Schaltkreis 200 kann eine Kombination aus einem Schalter und einem Proportionalregler umfassen, wobei der Schalter eine generelle Stromunterbrechung für das vom vorzugsweise elektrischen Temperierelement 200 umfasste Kühlelement bei einem einer von dem Temperatursensor 210 erfassten Temperatur, die kleiner ist, als eine vorgegebene Schwellentemperatur von beispielsweise 65°C proportionalen Ausgangssignal besorgt, und der Proportionalregler eine mit einem einer zunehmenden, von dem Temperatursensor 210 erfassten Temperatur, die größer ist, als eine vorgegebene Schwellentemperatur von beispielsweise 65°C proportionalen Ausgangssignal zunehmende Bestromung des Kühlelements besorgt.

Selbstverständlich kann der Schaltkreis 220 ein oder mehrere Proportional- und/oder Differential- und/oder Integralglieder (P-, D-, I-Glieder) und/oder Schalter umfassen, um eine gewünschte Regelcharakteristik des Temperierelements 200 und/oder eines vom Temperierelement 200 umfassten Heizelements und/oder eines gegebenenfalls alternativ oder zusätzlich vorgesehenen vom Temperierelement 200 umfassten Kühlelements zu erhalten.

Ein Temperierelement 200 und/oder ein Temperatursensor 210 können unmittelbar auf der OLED 20 angeordnet sein.

Das Leuchtmittel 100 kann zusätzlich einen Träger 10 umfassen, an dem die mindestens eine OLED 20 des Leuchtmittels 100 und das zumindest in wärmeleitendem Kontakt mit der OLED 20 stehende Temperierelement 200 angeordnet sind. Ein vorzugsweise elektrische Temperierelement 200 kann in diesem Fall alternativ oder zusätzlich zu einer Anordnung unmittelbar auf der OLED 20 auf und/oder in dem mit der mindestens einen OLED 20 verbundenen Träger 10 und/oder zwischen dem Träger 10 und der OLED 20 und/oder auf einer der OLED 20 abgewandten Seite des Trägers 10 angeordnet ist.

Alternativ oder zusätzlich kann ein Temperatursensor 210 in diesem Fall alternativ oder zusätzlich zu einer Anordnung unmittelbar auf der OLED 20 auf und/oder in dem mit der mindestens einen OLED 20 verbundenen Träger 10 und/oder zwischen dem Träger 10 und der OLED 20 und/oder auf einer der OLED 20 abgewandten Seite des Trägers 10 angeordnet sein.

Die mindestens eine OLED 20 kann mindestens einen Bereich mit wenigstens einer bei deren Betrieb leuchtenden Fläche 22 mit Abstrahlung von Licht in einer Richtung und/oder mindestens einen Bereich mit wenigstens einer bei deren Betrieb leuchtenden Fläche 21 mit Abstrahlung von Licht in zwei, beispielsweise entgegengesetzten Richtungen und/oder mindestens einen Bereich mit wenigstens einer Fläche 23, die transparent ist und nicht leuchtet und/oder mindestens einen Bereich mit wenigstens einer Fläche 24, die weder transparent ist, noch leuchtet aufweisen.

Eine Richtung, in welcher dabei bei Betrieb der mindestens einen OLED 20 eine Abstrahlung von Licht erfolgt ist dabei durch einen Kegel mit einem Öffnungswinkel von 0° bis 90° definiert, dessen Kegelachse normal auf der jeweiligen Fläche 21, 22 aufsteht. Vereinfacht betrachtet ist die Richtung, in welcher eine Abstrahlung erfolgt, durch die Flächennormale der jeweiligen Fläche 21, 22 gegeben.

Der gegebenenfalls vorgesehene Träger 10 kann auf einer Rückseite und/oder einer Vorderseite der mindestens einen OLED 20 angeordnet sein, beispielsweise in einem Bereich, in welchem die mindestens eine OLED 20 eine leuchtende Fläche 22 mit Abstrahlung in nur einer Richtung aufweist, wobei der Träger 10 bevorzugt auf derjenigen Seite der mindestens einen OLED 20 vorgesehen ist, in welcher Richtung keine Abstrahlung erfolgt, und/oder in einem Bereich, in welchem die mindestens eine OLED 20 eine Fläche 23, 24 aufweist, die nicht abstrahlend ist und entweder transparent oder nicht transparent ist.

Der gegebenenfalls vorgesehene Träger 10 kann selbst aus einem transparenten Werkstoff hergestellt sein, beispielsweise PMMA (PMMA: Polymethylmethacrylat). Dadurch kann der Träger 10 auch in einem oder mehreren Bereichen mit einer leuchtende Fläche 21 mit Abstrahlung in zwei Richtungen angeordnet sein und/oder auf derjenigen Seite eines oder mehrerer Bereiche mit einer leuchtende Fläche 22 mit Abstrahlung in einer Richtung, in welcher Richtung die Abstrahlung erfolgt.

Der gegebenenfalls vorgesehene Träger 10 kann in einem oder mehreren Bereichen der mindestens einen OLED 20 ausgespart sein, beispielsweise in einem oder mehreren Bereichen mit mindestens einer leuchtenden Fläche 22 mit Abstrahlung in einer Richtung und/oder mit mindestens einer leuchtenden Fläche 21 mit Abstrahlung in zwei Richtungen und/oder mindestens einer Fläche 23, die transparent und nicht abstrahlend ist.

Der Träger 10 kann mit einer TIR-Struktur 15 und/oder beispielsweise verspiegelten Prismen versehen sein. Alternativ oder zusätzlich können derartige TIR-Strukturen 15 und/oder Prismen auf einem oder mehreren Bereichen zumindest einer OLED 20 vorgesehen sein. Licht, welches beispielsweise von einer anderen Lichtquelle, als einer OLED 20 des Leuchtmittels 100 kommend oder seitlich aus einer OLED 20 des Leuchtmittels 100 austretend auf die Prismen und/oder einer TIR-Struktur 15 trifft kann durch diese in eine Richtung umgelenkt werden, in welcher es der Erfüllung einer Lichtverteilung beispielsweise einer Lichtfunktion einer Kraftfahrzeugleuchte 01 beiträgt oder zumindest beitragen kann.

Darüber hinaus kann eine der OLED 20 abgewandte Rückseite 12 des Trägers 10 mit Prismen und/oder einer TIR-Struktur 15 versehen sein, welche Licht, welches beispielsweise von einer anderen Lichtquelle, als der OLED 20 des Leuchtmittels 100 kommend oder seitlich aus der OLED 20 des Leuchtmittels 100 austretend auf die Prismen und/oder einer TIR-Struktur 15 trifft, in eine Richtung umlenkt, in welcher es der Erfüllung einer Lichtverteilung beispielsweise einer Lichtfunktion einer Kraftfahrzeugleuchte 01 beiträgt oder zumindest beitragen kann.

Der Träger 10 kann an zumindest einer - vorzugsweise an genau einer - seiner Schmalseiten Befestigungsmittel 30 aufweisen, mit denen er beispielsweise in einen von einem Leuchtengehäuse 02 und einer Lichtscheibe 03 umschlossenen Leuchteninnenraum 04 einer Kraftfahrzeugleuchte 01 kragend befestigt werden kann. Dadurch ist sichergestellt, dass sowohl bei der Montage, als auch während des Einsatzes im Kraftfahrzeug die OLED 20 spannungsfrei gehalten wird.

Besonders bevorzugt kann der Träger 10 eines solchen Leuchtmittels 100 an der den von dem Leuchtengehäuse 02 und mindestens einer Lichtscheibe 03 umschlossenen Leuchteninnenraum 04 der Kraftfahrzeugleuchte 01 in einen durch die Lichtscheibe 03 hindurch gesehen vor der Blende 05 liegenden und durch die Lichtscheibe 03 hindurch einsehbaren, ersten Bereich 41 und in einen durch die Lichtscheibe 03 hindurch gesehen hinter der Blende 05 liegenden und durch die Lichtscheibe 03 hindurch nicht einsehbaren, zweiten Bereich 42 unterteilenden Blende 05 in den ersten Bereich 41 kragend befestigt sein.

Hierbei weist vorzugsweise zumindest der Träger 10, gegebenenfalls aber wie in Fig. 2, Fig. 3, Fig. 4, Fig. 5 sowohl der Träger 10 zumindest an wenigstens einer - vorzugsweise an genau einer - seiner Schmalseiten, als auch die Blende 05 Befestigungsmittel 30 auf.

Der Träger 10 wenigstens eines Leuchtmittels 100 kann von der dem ersten Bereich 41 des Leuchteninnenraums 04 zugewandten Vorderseite 51 der Blende 05 durch diese hindurchgesteckt und mittels zumindest eines Teils der Befestigungsmittel 30 auf der dem zweiten Bereich 42 des Leuchteninnenraums 04 zugewandten Rückseite 52 der Blende 05 an der Blende 05 befestigt sein (Fig. 2 bis Fig. 4). Die Befestigungsmittel 30 können hierbei beispielsweise eine durch eine Blende 05 hindurchreichende Partie 31 des Trägers 10 sowie mindestens eine auf der Rückseite 52 der Blende 05 abstehende Auskragung 32 und mindestens eine auf der dem Träger 10 abgewandten Rückseite 52 der Blende 05 parallel zur Blende 05 angeordnete Klammer 33 umfassen. Die durch die Blende 05 hindurchreichende Partie 31 des Trägers 10 sowie die mindestens eine auf der Rückseite 52 der Blende 05 abstehenden Auskragung 32 weisen einander zugewandte, korrespondierende Führungsflächen auf. Die Klammer 33 umgreift die durch die Blende 05 hindurchreichende Partie 31 des Trägers 10 sowie mindestens eine auf der Rückseite 52 der Blende 05 abstehende Auskragung 32 und presst die einander zugewandten Führungsflächen der durch die Blende 05 hindurchreichende Partie 31 des Trägers 10 sowie mindestens einer auf der Rückseite 52 der Blende 05 abstehenden Auskragung 32 aneinander (Fig. 2 bis Fig. 4). Hierdurch erfolgt sowohl die Befestigung des Trägers 10 und damit des Leuchtmittels 100, als auch dessen vibrationssichere Halterung an der Blende 05.

Die Befestigungsmittel 30 können an der durch die Blende 05 hindurchreichenden Partie 31 des Trägers 10 und/oder an mindestens einer Auskragung 32 eine Kerbe 34 zur Aufnahme der Klammer 33 aufweisen (Fig. 2).

Die Befestigungsmittel 30 können ferner eine normal auf einer durch die Blende 05 im Bereich deren Durchdringung durch die Blende 05 hindurchreichenden Partie 31 des Trägers 10 gebildeten Fläche aufstehende Klammer 35 vorsehen, welche die Auskragung 32 und die durch die Blende 05 hindurchreichende Partie 31 des Trägers 10 von der der Blende 05 abgewandten Seite her umgreift (Fig. 4). Zur Aufnahme der Klammer 35 können die Befestigungsmittel 30 außerdem eine an mindestens einer Auskragung 32 und/oder an der die durch die Blende 05 hindurchreichenden Partie 31 des Trägers 10 vorgesehene, parallel zur Rückseite 52 der Blende 05 verlaufende Kerbe 36 umfassen (Fig. 2, Fig. 3).

Diese Klammer 35 verhindert ein Verkippen des Trägers 10 z, bei welchem Verkippen die Führungsfläche des Trägers 10 auf der der Blende 05 abgewandte Seite der durch die Blende 05 hindurchreichenden Partie 31 des Trägers 10 von der Führungsfläche zumindest einer Auskragung 32 abheben würde.

Auf der Vorderseite 51 der Blende 05 können die Befestigungsmittel 30 zusätzlich Abstützarme 37 aufweisen. Diese Abstützarme 37 befinden sich beim Blick in den Leuchteninnenraum 04 durch die Lichtscheibe 03 hindurch vorzugsweise auf der der Lichtscheibe 03 abgewandten Rückseite 12 des Trägers 10. Die Abstützarme 37 können wahlweise am Träger 10 oder an der Blende 10 angeordnet sein, oder um einer Fehlmontage vorzubeugen in einem vorgegebenen Muster an der Blende 05 und am Träger 10 verteilt angeordnet sein.

Alternativ oder zusätzlich kann der Träger 10 wenigstens eines Leuchtmittels 100 von der dem zweiten Bereich 42 des Leuchteninnenraums 04 zugewandten Rückseite 52 der Blende 05 durch diese hindurchgesteckt und mittels zumindest eines Teils der Befestigungsmittel 30 auf der dem zweiten Bereich 42 des Leuchteninnenraums 04 zugewandten Rückseite 52 der Blende 05 an der Blende 05 befestigt sein (Fig. 5).

Die Befestigungsmittel 30 können hierzu beispielsweise mindestens eine Anschlagfläche 38 und wenigstens einen Schraubdom 39 umfassen. Vermittels einer von der Rückseite 52 der Blende 05 aus gesehen durch die Anschlagfläche 38 in den Schraubdom 39 geschraubte Schraube 06 oder vermittels eines durch die Anschlagfläche 38 in den Schraubdom 39 reichenden Niets oder vermittels einer Klebe- oder Schweißverbindung zwischen Anschlagfläche 38 und Schraubdom 39 kann das Leuchtmittel 100 an der Blende 05 befestigt werden.

Der Träger 10 mitsamt der von diesem gehaltenen bzw. darauf angeordneten mindestens einen OLED 20 sowie des Temperierelements 200 kann von der Rückseite 52 beispielsweise einer in einem Leuchteninnenraum 04 einer Kraftfahrzeugleuchte 01 untergebrachten Blende 05 durch diese hindurchgesteckt und rückseitig mittels eines oder mehrerer Schraubdome 39 verschraubt sein.

Die Befestigungsmethoden können beispielsweise bei Anordnung mehrerer Leuchtmittel 100 in einem Leuchteninnenraum 04 oder in einer von mehreren einen Leuchteninnenraum 04 unterteilenden Leuchtenkammern kombiniert werden. Beispielsweise können Träger 10 von Leuchtmitteln 100 bei einer stark geneigten Anordnung gegenüber der Blende 05, wenn zumindest abschnittsweise kein Bauraum für einen rückseitigen Schraubdom 39 sowie für das Einbringen des Trägers 10 von der Rückseite 52 der Blende 05 her vorhanden ist, von der Vorderseite 51 der Blende 05 her mit den zuvor beschriebenen Befestigungsmitteln 30 angeordnet werden, wohingegen in Abschnitten, in denen eine Durchsteckmontage von hinten her möglich ist, Schraubdome 39 vorgesehen sein können.

Der Träger 10 kann darüber hinaus elektrische Kontakte bevorzugt an der mit Befestigungsmitteln 30 versehenen Schmalseite, vorzugsweise an seiner durch die Blende 05 hindurchreichenden Partie 31 aufweisen. Mit den elektrischen Kontakten kann die mindestens eine vom Träger 10 gehaltene OLED 20 mit Strom beaufschlagt werden.

Solche elektrischen Kontakte können darüber hinaus der Stromversorgung des Temperierelements 200 sowie der elektrischen Kontaktierung des Temperatursensors 210 und der Schaltung 220 dienen.

Beispielsweise kann der Träger 10 als im MID-Verfahren (MID; Molded Interconnect Device) spritzgegossener Schaltungsträger ausgeführt sein. Alternativ oder zusätzlich kann eine Platine am Träger 10 befestigt sein und die OLED mittels Kabelverbindung und/oder Flexplatine elektrisch kontaktiert sein.

Die Lichtscheibe 03 der Kraftfahrzeugleuchte 01 kann tiefgezogen oder im Spritzgussverfahren hergestellt sein. Die Lichtscheibe 03 der Kraftfahrzeugleuchte 01 ist bevorzugt aus Kunststoff hergestellt.

Die Kraftfahrzeugleuchte 01 kann mehrere beim Blick von außerhalb des Leuchteninnenraums 04 durch die Lichtscheibe 03 hindurch gesehen räumlich neben- und/oder hintereinander angeordnete, Leuchtmittel 100 mit jeweils einem Träger 10 und wenigstens einer an dem Träger 10 angeordneten bzw. von dem Träger 10 im Leuchteninnenraum 04 gehaltenen OLED 20 als Lichtquelle aufweisen.

Alternativ oder zusätzlich kann die Kraftfahrzeugleuchte 01 mindestens ein Leuchtmittel 100 mit einem Träger 10 und wenigstens einer an dem Träger 10 angeordneten bzw. von dem Träger 10 im Leuchteninnenraum 04 gehaltenen OLED 20 als Lichtquelle aufweisen, sowie mindestens ein zusätzliches in dem Leuchteninnenraum 04 beherbergtes und zur Erfüllung zumindest der selben oder einer weiteren Lichtfunktion der Kraftfahrzeugleuchte 01 vorgesehenes Leuchtmittel mit wenigstens einer Lichtquelle.

Zumindest eine Lichtquelle eines zur Erfüllung zumindest der selben oder einer weiteren Lichtfunktion der Kraftfahrzeugleuchte 01 vorgesehenen, zusätzlichen Leuchtmittels kann beim Blick von außerhalb des Leuchteninnenraums 04 durch die Lichtscheibe 03 hindurch gesehen hinter der mindestens einen von dem Träger 10 im Leuchteninnenraum 04 gehaltenen OLED 20 angeordnet sein, so dass wenigstens eine OLED 20 im direkten Strahlengang des von der zumindest einen Lichtquelle des zur Erfüllung zumindest der selben oder einer weiteren Lichtfunktion der Kraftfahrzeugleuchte 01 vorgesehenen, zusätzlichen Leuchtmittels zur Lichtscheibe 03 liegt.

Damit das von einer Lichtquelle eines solchen, zur Erfüllung zumindest der selben oder einer weiteren Lichtfunktion der Kraftfahrzeugleuchte 01 vorgesehenen, zusätzlichen Leuchtmittels abgestrahlte Licht dennoch durch Lichtscheibe 03 hindurch aus dem Leuchteninnenraum 04 austreten kann, kann der mindestens eine OLED 20 im Leuchteninnenraum 04 haltende Träger 10 eine beispielsweise zentrale Lichtöffnung 11 beispielsweise für von einer beim Blick durch eine Lichtscheibe 03 der Kraftfahrzeugleuchte 01 hindurch gesehen hinter dem Träger 10 angeordneten Lichtquelle eines zur Erfüllung zumindest der selben oder einer weiteren Lichtfunktion der Kraftfahrzeugleuchte 01 vorgesehenen, zusätzlichen, beispielsweise mit einem Leuchtmittel 100 mit einem Träger 10 und mindestens einer von diesem gehaltenen OLED 20 identischen Leuchtmittels abgestrahltes Licht aufweisen.

Durch das Unterbringen mehrerer OLEDs 20 in einer Kraftfahrzeugleuchte 01 kann es zu gegenseitigen Abschattungen der OLEDs 20 kommen, was zur Folge hat, das einzelne Winkelbereiche eine zu geringe Lichtstärke in Bezug auf die beispielsweise gesetzlich geforderten, von einer Lichtverteilung vorgegebenen Lichtwerte aufweisen. Durch beispielsweise zentrale Lichtöffnungen 11 zumindest in den Trägern 10 der vorderen, der Lichtscheibe 03 näheren Leuchtmittel 100 mehrerer beim Blick von außerhalb des Leuchteninnenraums 04 durch die Lichtscheibe 03 hindurch gesehen räumlich neben- und/oder hintereinander angeordneter Leuchtmittel 100 mit jeweils einem Träger 10 und wenigstens einer an dem Träger 10 angeordneten bzw. von dem Träger 10 im Leuchteninnenraum 04 gehaltenen OLED 20 als Lichtquelle kann dieser gegenseitigen Abschattung zur Erhöhung der Lichtwerte in einzelnen Winkelbereichen entgegengewirkt werden.

Zumindest zwei von mindestens zwei Lichtfunktionen der Kraftfahrzeugleuchte 01 können unterschiedliche Lichtfarben aufweisen.

Wichtig ist hervorzuheben, dass die Kraftfahrzeugleuchte 01 zusätzlich zu der durch die mindestens eine mit wenigstens einem Temperierelement 200 zumindest in wärmeleitendem Kontakt stehende OLED 20 zu erfüllenden Lichtfunktion über mindestens eine konventionell vermittels beispielsweise eines oder mehrerer beispielsweise in einer separaten Reflektorkammer untergebrachten Leuchtmittels und/oder eines Lichtleiters verwirklichte, zusätzliche Lichtfunktion verfügen kann. Bei dieser mindestens einen zusätzlichen Lichtfunktion kann es sich beispielsweise um eine solche Lichtfunktion handeln, deren Lichtwerte und/oder deren gesetzliche Vorschriften vermittels einer flächigen Lichtquelle wie einer OLED 20 nur unter hohem Aufwand zu erfüllen sind.

Alternativ oder zusätzlich können eine oder mehrere Lichtfunktionen unabhängig von der Kraftfahrzeugleuchte 01 untergebracht sein. Beispielsweise können eine der Erfüllung einer Nebelschlusslichtfunktion dienende Nebelschlussleuchte und/oder ein der Erfüllung einer Rückfahrlichtfunktion dienender Rückfahrscheinwerfer zusammen in einem Modul der Kraftfahrzeugleuchte 01 örtlich ausgelagert sein, während sich in einem anderen Bereich der Kraftfahrzeugleuchte 01 die verbleibenden Lichtfunktionen konzentrieren. Ein Grund hierfür kann beispielsweise sein, dass die Nebelschlusslichtfunktion einen Mindestabstand zum Bremslichtfunktion aufgrund gesetzlicher Vorgaben einhalten muss. Durch diese Abtrennung ist dann zusätzlich eine größere Gestaltungsfreiheit gegeben.

Mit anderen Worten können in dem beispielsweise von einem Leuchtengehäuse 02 und einer Lichtscheibe 03 zumindest zum Teil umschlossenen Leuchteninnenraum 04 der Kraftfahrzeugleuchte 01 eine oder mehrere Lichtquellen:
- des selben Leuchtmittels 100 beherbergt sein, wie das Leuchtmittel 100, welches die mindestens eine von dem Träger 10 getragene OLED 20 umfasst (Fig. 7), und/oder
- mindestens eines zur Erfüllung der selben Lichtfunktion vorgesehenen Leuchtmittels beherbergt sein, wie der von dem die mindestens eine von dem Träger 10 getragenen OLED 20 umfassenden Leuchtmittel 100 erfüllten, und/oder
- mindestens eines weiteren Leuchtmittels beherbergt sein, als dem Leuchtmittel 100, welches die mindestens eine von dem Träger 10 getragene OLED 20 umfasst bzw. bei welchem mindestens einen weiteren Leuchtmittel es sich nicht um das Leuchtmittel 100 handelt, welches die mindestens eine von dem Träger 10 getragene OLED 20 umfasst, und/oder
- mindestens eines zur Erfüllung einer anderen Lichtfunktion vorgesehenen Leuchtmittels beherbergt sein, als der von dem die mindestens eine von dem Träger 10 getragenen OLED 20 umfassenden Leuchtmittel erfüllten.

Damit können bei einer Kraftfahrzeugleuchte 01 eine oder mehrere Lichtquellen:
- des selben Leuchtmittels 100 beherbergt sein, wie das Leuchtmittel 100, welches die mindestens eine mit dem mindestens einen Temperierelement 200 zumindest in wärmeleitendem Kontakt stehende OLED 20 umfasst, und/oder
- mindestens eines zur Erfüllung der selben Lichtfunktion vorgesehenen Leuchtmittels beherbergt sein, wie der von dem die mit dem mindestens einen Temperierelement 200 zumindest in wärmeleitendem Kontakt stehende OLED 20 umfassenden Leuchtmittel 100 erfüllten, und/oder
- mindestens eines weiteren Leuchtmittels beherbergt sein, als dem Leuchtmittel 100, welches die mindestens eine mit dem mindestens einen Temperierelement 200 zumindest in wärmeleitendem Kontakt stehende OLED 20 umfasst, und/oder
- mindestens eines zur Erfüllung einer anderen Lichtfunktion vorgesehenen Leuchtmittels beherbergt sein, als der von dem die mindestens eine mit dem mindestens einen Temperierelement 200 zumindest in wärmeleitendem Kontakt stehende OLED 20 umfassenden Leuchtmittel 100 erfüllten.

Die bevorzugt als Heckleuchte ausgeführte Kraftfahrzeugleuchte 01 kann einen von einem Leuchtengehäuse 02 und einer Lichtscheibe 03 umschlossenen Leuchteninnenraum 04 aufweisen. Die Kraftfahrzeugleuchte 01 verfügt über mindestens eine Lichtfunktion. Alternativ kann die Kraftfahrzeugleuchte 01 über zumindest zwei Lichtfunktionen verfügen. Hierbei kann es sich um eine Rücklichtfunktion und/oder eine Bremslichtfunktion und/oder eine Wiederholblinklichtfunktion und/oder eine Rückfahrlichtfunktion und/oder eine Nebelschlusslichtfunktion handeln, um nur einige denkbare Ausgestaltungen verschiedener Lichtfunktionen zu nennen. Alternativ oder zusätzlich sind weitere Lichtfunktionen denkbar. Mindestens zwei der Lichtfunktionen der Kraftfahrzeugleuchte 01 können unterschiedlicher Lichtfarbe sein.

Das mindestens eine Leuchtmittel 100 mit mindestens einer an einem gegebenenfalls vorgesehenen Träger 10 angeordneten bzw. von dem Träger 10 gehaltenen und bevorzugt via des Trägers 10 elektrisch kontaktierten OLED 20 als Lichtquelle kann wenigstens eine OLED 20 mit mindestens einer leuchtenden Fläche 22 mit Abstrahlung in einer Richtung und/oder mindestens eine Fläche 24, die nicht abstrahlend und nicht transparent ist, weil sie beispielsweise metallisiert sein kann aufweisen. Die wenigstens eine OLED 20 ist mechanisch und thermisch an den Träger 10 angebunden. Mindestens eine leuchtende Fläche 22 mit Abstrahlung in einer Richtung ist auf ihrer der Lichtabstrahlung abgewandten Seite mit dem Träger 10 versehen bzw. weist Kontaktflächen zum Träger 10 auf und/oder mindestens eine Fläche 24, die nicht abstrahlend und nicht transparent ist, ist mit dem Träger 10 versehen bzw. weist Kontaktflächen zum Träger 10 auf.

Bevorzugt weist bei dem Leuchtmittel 100 ausschließlich mindestens eine leuchtende Fläche 22 mit Abstrahlung in einer Richtung auf ihrer der Lichtabstrahlung abgewandten Seite und/oder mindestens eine Fläche 24, die nicht abstrahlend und nicht transparent ist Kontaktflächen zum Träger auf, bzw. bevorzugt sind ausschließlich solche Flächen 22, 24 mit dem Träger 10 versehen.

Die mindestens eine OLED 20 eines Leuchtmittels 100 kann zusätzlich mindestens eine leuchtende Fläche 21 mit Abstrahlung in zwei Richtungen und/oder mindestens eine Fläche 23, die transparent und nicht abstrahlend ist, aufweisen.

Wenigstens eine OLED 20 des Leuchtmittels 100 zeichnet sich demnach dadurch aus, dass sie mindestens eine Fläche bzw. Partie mit einer oder mehreren Eigenschaften aus den folgenden drei Kategorien aufweist:
- leuchtende Fläche 21 mit Abstrahlung in zwei Richtungen,
- leuchtende Fläche 22 mit Abstrahlung in einer Richtung,
- Fläche 23, die transparent und nicht abstrahlend ist,
- Fläche 24, die weder transparent, noch abstrahlend ist, weil sie beispielsweise metallisiert sein kann.

Vorzugsweise weisen damit nur Flächen 24, die weder abstrahlend, noch transparent sind Kontaktflächen zum Träger 10 auf, und/oder leuchtende Flächen 22 mit Abstrahlung in einer Richtung auf ihrer der Lichtabstrahlung abgewandten Seite Kontaktflächen zum Träger 10 auf.

Sofern eine OLED 20 neben einer oder mehreren leuchtenden Flächen 22 mit Abstrahlung in einer Richtung, welche auf ihrer der Lichtabstrahlung abgewandten Seite Kontaktflächen zum Träger 10 aufweisen, umfasst, weisen die verbleibenden, Kontaktflächen zum Träger aufweisenden Flächen 24, die weder abstrahlend, noch transparent sind auf der selben, der Lichtabstrahlung der leuchtenden Flächen 22 mit Abstrahlung in einer Richtung abgewandten Seite ihre Kontaktflächen zum Träger 10 auf.

Ein Leuchtmittel 100 zeichnet sich demnach beispielsweise dadurch aus, dass die wenigstens eine OLED 20, welche zusätzlich zu bzw. neben einer leuchtenden Fläche 22 mit Abstrahlung in einer Richtung und/oder einer Fläche 24, die weder abstrahlend, noch transparent sind, eine oder mehrere leuchtende Flächen 21 mit Abstrahlung in zwei Richtungen und/oder eine oder mehrere Flächen 23, die transparent und nicht abstrahlend ist aufweisen kann, mechanisch und thermisch an den Träger 10 angebunden ist, wobei vorzugsweise nur die leuchtenden Fläche 22 mit Abstrahlung in einer Richtung und/oder einer Fläche 24, die weder abstrahlend, noch transparent sind auf der der Lichtabstrahlung abgewandten Seite mit dem Träger 10 versehen sind bzw. Kontaktflächen zum Träger 10 aufweisen.

Sich hierdurch ergebende Vorteile sind eine einwandfreie spannungsfreie Halterung von OLEDs 20 auf dem Träger 10, ohne deren Lichtabstrahlung zu behindern, einhergehend mit einer thermischen Ankopplung, um beim Betrieb der OLED 20 entstehende Wärme optimal abführen zu können.

Durch Verwendung eines Leuchtmittels 100 mit mindestens einer OLED 20 als Lichtquelle, die mit mindestens einem Temperierelement in zumindest wärmeleitendem Kontakt steht, können darüber hinaus thermische und elektrische Vorgaben erfüllt werden, wie sie beispielsweise durch den Standard LV 124 vorgegeben sind.

Damit einhergehende Vorteile sind die Vermeidung von Schäden, die wegen des Aufbaus von OLEDs 20 mit eine Vorder- bzw. Rückseite der OLED 20 bildenden Deck- und Rückflächen aus jeweils dünnen Glasplättchen oder Kunststoffplättchen beim Einsatz in Kraftfahrzeugleuchten 01 auftreten würden, wenn OLEDs 20 nicht frei von mechanischen Spannungen untergebracht werden können, und der Erhalt einer Kühlung bzw. Abfuhr der beim Betrieb von OLEDs 20 entstehenden Wärme, die für den tatsächlichen Gebrauch von OLEDs 20, die sehr temperaturempfindlich sind, in Kraftfahrzeugleuchten 01 erforderlich ist. Darüber hinaus können hierdurch OLEDs beheizt werden, um ihren im Vergleich zu dem von LEDs ansonsten ungewöhnlichen Spannungsverlauf bei niederen Temperaturen in den Griff zu bekommen.

Die Erfindung ermöglicht dadurch, OLEDs 20 unter den im Betrieb von Kraftfahrzeugleuchten 01 auftretenden mechanischen und thermischen Belastungen einzusetzen und damit für den tatsächlichen Gebrauch in Kraftfahrzeugen vorzusehen.

Der Träger 10 des Leuchtmittels 100 kann in einem oder mehreren Bereichen mindestens einer leuchtenden Fläche 21 mit Abstrahlung in zwei Richtungen und/oder mindestens einer Fläche 23, die transparent und nicht abstrahlend ist, ausgespart sein.

Eine derartige Aussparung kann beispielsweise durch eine bereits erwähnte, beispielsweise zentrale Lichtöffnung 11 verwirklicht sein. Mit anderen Worten kann die bereits erwähnte, beispielsweise zentrale Lichtöffnung 11 zumindest zum Teil von einer leuchtenden Fläche 21 mit Abstrahlung in zwei Richtungen und/oder mindestens einer Fläche 23, die transparent und nicht abstrahlend ist der OLED 20 abgedeckt sein.

Durch die beispielsweise zentrale Lichtöffnung 11 kann alternativ oder zusätzlich beispielsweise bei in eine Kraftfahrzeugleuchte 01 eingebautem Leuchtmittel 100 Licht einer beim Blick durch eine Lichtscheibe 03 der Kraftfahrzeugleuchte 01 hindurch gesehen hinter dem Träger 10 angeordneten, weiteren Lichtquelle als der mindestens eine von dem Träger 10 gehaltenen OLED 20 hindurchtreten. Eine solche Lichtquelle kann bei in eine Kraftfahrzeugleuchte 01 eingebautem Leuchtmittel 100 beispielsweise für eine andere Lichtfunktion vorgesehen sein, als die auf dem Träger 10 des Leuchtmittels 100 angeordnete mindestens eine OLED 20.

Bei einem Leuchtmittel 100 kann die mindestens eine an dem Träger 10 angeordnete bzw. von dem Träger 10 oder vermittels des Trägers 10 gehaltene OLED 20 via des Trägers 20 elektrisch kontaktiert sein. Dies ermöglicht bei einer Befestigung an einer beispielsweise einen Leuchteninnenraum 04 einer Kraftfahrzeugleuchte 01 in einen durch die Lichtscheibe 03 hindurch gesehen vor der Blende 05 liegenden und durch die Lichtscheibe 03 hindurch einsehbaren, ersten Bereich 41 und in einen durch die Lichtscheibe 03 hindurch gesehen hinter der Blende 05 liegenden und durch die Lichtscheibe 03 hindurch nicht einsehbaren, zweiten Bereich 42 einteilenden Blende 05 eine einfache, verdeckt angeordnete Stromversorgung der einen oder mehreren von dem oder den Trägern 10 eines oder mehrerer Leuchtmittel 100 im Leuchteninnenraum 04 gehaltenen OLEDs 20.

Bei dem Leuchtmittel 100 kann:
- mindestens eine Fläche 23, die transparent und nicht abstrahlend ist zumindest in einem oder mehreren Bereichen Prismen und/oder eine TIR-Struktur 15 (totalreflektierende Struktur; Total Internal Reflection) aufweisen, und/oder
- eine der OLED 20 abgewandte Rückseite 12 des Trägers 10 mit Prismen und/oder einer TIR-Struktur 15 versehen sein, und/oder
- mindestens eine leuchtenden Fläche 21 mit Abstrahlung in zwei Richtungen zumindest in einem oder mehreren Bereichen Prismen und/oder eine TIR-Struktur 15 aufweisen.

Eine Fläche 21 mit Abstrahlung in zwei Richtungen der OLED 20 kann vorzugsweise auf der dem Träger 10 zugewandten Rückseite der OLED 20 mit einer Optik in Form von Prismen und/oder einer TIR-Struktur 15 versehen sein, sofern erwünscht oder erforderlich.

Licht, welches beispielsweise von einer anderen Lichtquelle, als der OLED 20 des Leuchtmittels 100 kommend oder seitlich aus der OLED 20 des Leuchtmittels 100 austretend auf die Prismen und/oder einer TIR-Struktur 15 trifft kann durch die zumindest in einem oder mehreren Bereichen mindestens einer Fläche 23, die transparent und nicht abstrahlend ist vorgesehenen Prismen und/oder die dort vorgesehene TIR-Struktur 15 in eine Richtung umgelenkt werden, in welcher es der Erfüllung einer Lichtverteilung beispielsweise einer Lichtfunktion einer Kraftfahrzeugleuchte 01 beiträgt oder zumindest beitragen kann.

Eine mit Prismen und/oder einer TIR-Struktur 15 versehene, der OLED 20 abgewandte Seite des Trägers 10 kann Licht, welches beispielsweise von einer anderen Lichtquelle, als der OLED 20 des Leuchtmittels 100 kommend oder seitlich aus der OLED 20 des Leuchtmittels 100 austretend auf die Prismen und/oder einer TIR-Struktur 15 trifft, in eine Richtung umlenken, in welcher es der Erfüllung einer Lichtverteilung beispielsweise einer Lichtfunktion einer Kraftfahrzeugleuchte 01 beiträgt oder zumindest beitragen kann.

Durch Prismen und/oder eine TIR-Struktur 15 zumindest in einem oder mehreren Bereichen mindestens einer leuchtenden Fläche 21 mit Abstrahlung in zwei Richtungen kann:
- sowohl Licht, das von der OLED 20 des Leuchtmittels 100 kommend oder seitlich aus der OLED 20 des Leuchtmittels 100 austretend auf die Prismen und/oder die TIR-Struktur 15 trifft umgelenkt werden und dadurch der Erfüllung einer Lichtverteilung beispielsweise einer Lichtfunktion einer Kraftfahrzeugleuchte 01 beitragen,
- als auch Licht, das von einer anderen Lichtquelle, als der OLED 20 des Leuchtmittels 100 kommend auf die Prismen und/oder einer TIR-Struktur 15 trifft, in eine Richtung umgelenkt werden, in welcher es der Erfüllung einer Lichtverteilung beispielsweise einer Lichtfunktion einer Kraftfahrzeugleuchte 01 beiträgt oder zumindest beitragen kann.

Die Prismen und/oder die TIR-Struktur 15 tragen damit zu einer Steiegeung der optischen Güte des Leuchtmittels 100 und/oder einer mit mindestens einem solchen Leuchtmittel 100 ausgestatteten Kraftfahrzeugleuchte 01 bei.

Die wenigstens eine OLED 20 des Leuchtmittels 100 weist mindestens eine leuchtende Fläche 22 mit Abstrahlung in einer Richtung auf. Diejenige eine Rückseite der OLED 20 bildende Oberfläche, die der Richtung entgegengesetzt ist, in welche gesehen die leuchtende Fläche 22 mit Abstrahlung in einer Richtung abstrahlt, als Kontaktfläche zum Träger 10 dient. Der Träger 10 weist bevorzugt eine mit der mindestens einen leuchtende Fläche 22 mit Abstrahlung in einer Richtung der OLED 20 in ihrer Geometrie und in ihren Abmessungen identische Befestigungsfläche 14 auf, auf welcher die OLED 20 mit ihrer Rückseite befestigt ist.

Hierdurch erfolgt eine besonders effektive Abfuhr insbesondere der in der leuchtenden Fläche 22 der mit Abstrahlung in einer Richtung beim Betrieb der OLED 20 entstehenden Wärme, ohne dass der Gesamteindruck einer eine Leuchtfläche bildenden OLED 20 durch überstehende, störende und nicht leuchtende Flächen und/oder Flächen des Trägers 10 beeinträchtigt wird.

Darüber hinaus wird hierdurch eine Vergleichmäßigung der Wärmeverteilung an der OLED 20 erreicht, wodurch eine verbesserte, homogenere Abstrahlung der OLED 20 über die Leuchtfläche hinweg erreicht wird.

Die Erfindung löst damit die dem Erhalt sowohl einer größtmöglichen optischen Güte, als auch zum notwendigen Walten von Sorgfalt beim Umgang mit OLEDs 20 entgegenstehenden Probleme einer bestmöglichen thermischen Ankopplung der OLED 20 und deren spannungsfreier Befestigung gleichzeitig und gleichermaßen durch einen Träger 10, auf den eine OLED 20 beispielsweise durch Aufkleben spannungsfrei befestigt wird, und welcher Träger 10 im Leuchteninnenraum 04 einer Kraftfahrzeugleuchte 01 befestigt werden kann.

Der Träger 10 des Leuchtmittels 100 kann aus einem transparenten Material hergestellt sein. Hierdurch entsteht ein frei schwebender Eindruck der Leuchtfläche der OLED 20 sowohl in ausgeschaltetem Zustand, als auch während deren Betriebs beispielsweise im in den Leuchteninnenraum 04 einer Kraftfahrzeugleuchte 01 eingebauten Zustand. Durch die Verwendung transparenten Materials kann die optische Güte des Leuchtmittels 100 nochmals gesteigert werden, da weniger Lichtleistung verloren geht. Dies ist dadurch begründet, da in Richtung des Trägers 10 von der OLED 20 abgestrahltes Licht, wie etwa Streulicht oder Licht einer leuchtenden Fläche 21 mit Abstrahlung in zwei Richtungen von dem transparenten Träger 10 nicht oder zumindest nur geringfügig absorbiert wird, sondern einem Beitrag zu einer Lichtverteilung einer Lichtfunktion beispielsweise einer Kraftfahrzeugleuchte 01 zugeführt werden kann.

Der Träger 10 des Leuchtmittels 100 und/oder die beispielsweise der Richtung der Abstrahlung einer leuchtenden Fläche 22 mit Abstrahlung in einer Richtung abgewandte Rückseite der mindestens einen von dem Träger 10 gehaltenen OLED 20 kann im Bereich wenigstens einer leuchtenden Fläche 22 mit Abstrahlung in einer Richtung und/oder einer Fläche 24, die weder abstrahlend, noch transparent ist metallisiert und/oder verspiegelt sein. Alternativ oder zusätzlich kann der Träger 10 aus einem Metall und/oder einem Halbleitermaterial und/oder einer Keramik hergestellt sein.

Denkbar ist demnach auch, dass der Träger 10 im Bereich wenigstens einer leuchtende Fläche 21 mit Abstrahlung in zwei Richtungen der OLED 20, die mit Prismen und/oder einer TIR-Struktur 15 versehen sein kann, halbtransparent ausgeführt ist, wobei in Richtung des Trägers 10 abgestrahltes Licht der OLED 20 umgelenkt bzw. reflektiert wird und beispielsweise wieder durch die OLED 20 hindurch gestrahlt wird. Die Vorderseite der OLED 20 strahlt dann ohne Einfluss des Trägers 10 ab und die Abstrahlung der Rückseite der OLED 20 wird durch die Optik in Form von Prismen und/oder einer TIR-Struktur 15 an dem Träger 10 beeinflusst.

Eine reflektierende Ausführung des Trägers 10 kann demnach durch Verwendung eines transparenten, klaren Materials für den Träger 10 in Verbindung mit totalreflektierenden Optiken, wie etwa einer TIR-Struktur 15 auf dessen der Richtung der Abstrahlung einer leuchtenden Fläche 22 mit Abstrahlung in einer Richtung der OLED 20 abgewandte Rückseite verwirklicht sein, und/oder durch eine spiegelnde und reflektierende Beschichtung.

Der Träger 10 kann als ein Spritzgussteil hergestellt sein.

Die OLED 20 kann auf den Träger 10 aufgeklebt sein.

Das Temperierelement 200 kann auf den Träger und/oder auf die OLED 20 aufgeklebt und/oder zwischen OLED 20 und Träger 10 geklebt sein.

Es ist ersichtlich, dass die Erfindung in jedem Fall dadurch verwirklicht sein kann, OLEDs im Temperaturbereich beispielsweise unter 0°C zu beheizen. Dies kann erfolgen, indem die OLED beispielsweise auf einem Träger mit hinterlegtem, beispielsweise als elektrische Heizwendel ausgeführtem elektrischem Heizelement, ähnlich einer Beheizung eines Spiegelglases eines Außenrückblickspiegels angeordnet wird, oder indem beispielsweise auf ein vorzugsweise rückseitiges Glasplättchen einer OLED ein Heizelement beispielsweise in Form einer solchen elektrischen Heizwendel aufgebracht wird, und die Heizwendel unter Verwendung einer entsprechenden Sensorik unterhalb einer vorgegebenen Grenztemperatur betrieben wird.

Es ist ersichtlich, dass die Erfindung ergänzend zu einer beispielsweise durch Beheizung und/oder Kühlung erfolgenden Temperierung einer OLED 20 verwirklicht sein kann durch ein Leuchtmittel 100 mit einer oder mehreren auf einem Träger 10 durch beispielsweise durch Aufkleben spannungsfrei befestigten OLEDs 20 als Lichtquelle, wobei der Träger 10 auf seiner der mindestens einen auf ihm angeordneten OLED 20 abgewandten Rückseite 12 und/oder die mindestens eine auf dem Träger angeordnete OLED 20 auf deren frei von dem Träger 10 ausgeführten Rückseite reflektierend ausgeführt ist.

Die Erfindung kann alternativ oder zusätzlich ergänzend zu einer beispielsweise durch Beheizung und/oder Kühlung erfolgenden Temperierung einer OLED 20 verwirklicht sein durch ein Leuchtmittel 100 mit einer oder mehreren auf einem Träger 10 durch beispielsweise durch Aufkleben spannungsfrei befestigten OLEDs 20 als Lichtquelle, wobei der Träger 10 nur an solchen Partien bzw. Flächen 22, 24 der mindestens einen OLED 20 vorgesehen ist, die entweder nur in einer Richtung weg von dem Träger 10 abstrahlen, und/oder die weder transparent, weil beispielsweise metallisiert, noch vorzugsweise leuchtend sind.

Denkbar ist ferner, dass die Erfindung alternativ oder zusätzlich ergänzend zu einer beispielsweise durch Beheizung und/oder Kühlung erfolgenden Temperierung einer OLED 20 verwirklicht sein kann durch ein Leuchtmittel 100 mit einer oder mehreren auf einem Träger 10 durch beispielsweise durch Aufkleben spannungsfrei befestigten OLEDs 20 als Lichtquelle und mindestens einer, beispielsweise zentralen Lichtöffnung 11, durch welche Licht einer oder mehrerer Lichtquellen eines oder mehrerer gleichartiger und/oder verschiedenatiger Leuchtmittel hindurchtreten kann, wobei die Lichtöffnung 11 von mindestens einem transparenten Bereich wenigstens einer OLED 20 abgedeckt sein kann, welcher transparente Bereich beispielsweise von einer leuchtenden Fläche 21 mit Abstrahlung in zwei Richtungen wenigstens einer OLED 20 und/oder beispielsweise von einer Fläche 23, die transparent und nicht abstrahlend ist, wenigstens einer OLED 20 gebildet sein kann.

Eine alternative oder zusätzliche Möglichkeit zur Verwirklichung der Erfindung ergänzend zu einer beispielsweise durch Beheizung und/oder Kühlung erfolgenden Temperierung einer OLED 20 ergibt sich durch eine Kraftfahrzeugleuchte 01 mit einem oder mehreren solchen Leuchtmitteln 100, die beispielsweise teilweise einander überlappend beispielsweise in einem von einem Leuchtengehäuse 02 und einer Lichtscheibe 04 zumindest zum Teil umschlossenen Leuchteninnenraum 04 angeordnet sein können, wobei bei mehreren jeweils eine oder mehrere OLEDs 20 als Lichtquellen aufweisenden Leuchtmitteln 100 jede der OLEDs 20 auf einem eigenen Träger 10 beispielsweise durch Aufkleben spannungsfrei befestigt ist, wobei bei mehreren solchen, einander gegebenenfalls beispielsweise teilweise einander überlappend angeordneten Leuchtmitteln 100 der Träger 10 zumindest eines Leuchtmittels 100 auf seiner der auf ihm angeordneten, beispielsweise aufgeklebten OLED 20 abgewandten und einer zumindest teilweise dahinter auf einem eigenen Träger 10 angeordneten, beispielsweise aufgeklebten OLED 20 zugewandten Rückseite 12 reflektierend ausgeführt sein kann, beispielsweise vermittels einer dort angeordneten TIR-Struktur 15.

Durch Verwendung eines oder mehrerer zuvor beschriebener Leuchtmittel 100 gegebenenfalls zusätzlich zu einem oder mehreren, zur Erfüllung der selben oder einer oder mehrerer weiterer Lichtfunktionen der Kraftfahrzeugleuchten 01 vorgesehenen Leuchtmittel ist es möglich, vermittels auch aus designtechnischer Sicht gefälliger und akzeptabler Maßnahmen auch Anordnungen von OLEDs 20 in einer Kraftfahrzeugleuchte 01 zu verwirklichen, bei denen es ansonsten zu Abschattungen zwischen den OLEDs 20 kommen kann.

Anzumerken ist hierbei, dass die OLEDs 20 auch aus den seitlichen Kanten Licht emittieren können. Dadurch wird das Problem gegenseitiger Abschattung ohne gesonderte Maßnahmen zwar teilweise reduziert, aber oft nicht vollständig gelöst.

Die Verwendung eines oder mehrerer zuvor beschriebener Leuchtmittel 100 in einer Kraftfahrzeugleuchte 01 löst das Problem hingegen vollständig, insbesondere wenn der Träger 10 bei einem oder mehreren der vorgesehenen mit einem Träger 10 und wenigstens einer von diesem gehaltenen OLED 20 ausgestatteten Leuchtmittel 100 mit einer beispielsweise zentralen Lichtöffnung 11 ausgestattet ist und/oder Prismen und/oder TIR-Strukturen 15 auf der Rückseite des Trägers 10 und/oder der OLED 20 vorgesehen sind, welche ansonsten durch Abschattung verloren gehendes Licht derart passieren lassen und/oder umlenken, dass es schließlich unter Beitrag zur Lichtverteilung einer Lichtfunktion beispielsweise einen von einem Leuchtengehäuse 02 und einer Lichtscheibe 04 zumindest zum Teil umschlossenen Leuchteninnenraum 04 einer Kraftfahrzeugleuchte 01 durch die Lichtscheibe 03 hindurch verlässt.

Um diesen Beitrag nochmals zu erhöhen, kann in dem Leuchteninnenraum 04 einer Kraftfahrzeugleuchte 01 ein Reflektor vorgesehen sein, welcher nach hinten, weg von der Lichtscheibe 03 gestrahltes oder umgelenktes Licht wieder zurück in Richtung der Lichtscheibe 03 wirft und dabei bevorzugt zugleich derart umlenkt, dass dieses Licht einen Beitrag zu einer Lichtverteilung einer Lichtfunktion der Kraftfahrzeugleuchte 01 beiträgt. Als Reflektor kann dabei beispielsweise mindestens ein verspiegelter Abschnitt einer Vorderseite 51 einer Blende 05 dienen, welche den Leuchteninnenraum 04 in einen durch die Lichtscheibe 03 hindurch gesehen vor der Blende 05 liegenden und durch die Lichtscheibe 03 hindurch einsehbaren, ersten Bereich 41 und in einen durch die Lichtscheibe 03 hindurch gesehen hinter der Blende 05 liegenden und durch die Lichtscheibe 03 hindurch nicht einsehbaren, zweiten Bereich 42 einteilt.

Wichtig ist hervorzuheben, dass:
- der gegebenenfalls vorgesehene Träger 10 eines zur Verwendung in einer Kraftfahrzeugleuchte 01 geeigneten Leuchtmittels 100 neben der spannungsfreien Aufnahme der OLEDs 20 beim direkten Blick und zusätzlich in einem gewissen Winkelbereich auf die OLED 20 so ausgestaltet werden kann, dass er für einen Betrachter von außerhalb des Leuchteninnenraums 04 einer Kraftfahrzeugleuchte 01 durch deren Lichtscheibe 03 hindurch gesehen nicht oder nur geringfügig sichtbar ist. Bei OLEDs 20 mit einer leuchtenden Fläche 22 mit Abstrahlung in einer Richtung funktioniert dies sehr gut, da deren leuchtende Flächen eine metallische Schicht (Kathode oder Anode oder allgemein Elektrode) benötigen. Diese ist somit spiegelnd und nichttransparent ausgeführt. Daher verdeckt diese auch im Kaltzustand den Träger 10, welcher die OLED 20 im Leuchteninnenraum 04 trägt.
- bei transparenten OLEDs 20 die metallische Schicht aus ITO (Indiumzinnoxid) oder einem ähnlichen Material ausgeführt ist, welches zumindest bei dünner Ausführung transparent und elektrisch leitfähig ist. Transparente OLEDs 20 weisen damit mindestens eine leuchtende Fläche 21 mit Abstrahlung in zwei Richtungen auf. Dementsprechend wäre ein hinter einer solchen leuchtenden Fläche 21 mit Abstrahlung in zwei Richtungen angeordneter Träger 10 sichtbar. Der Träger 10 kann allerdings - abhängig von der Größe, dem Gewicht und der Geometrie der OLED 20 - nur einen kleinen Bereich der OLED 20 von hinten stützen, dadurch ist der Träger 10 dann nur geringfügig sichtbar. Beispielsweise kann der Träger 10 nur in einem Bereich 42 hinter der Blende 05 mit einer Kontaktfläche zum Träger 10 versehen sein - bzw. die Klebung erfolgt nur im Bereich 42 hinter der Blende 05, wodurch die OLED 20 einem Betrachter beim Blick von außerhalb des Leuchteninnenraums 04 durch die Lichtscheibe 03 hindurch als in der Kraftfahrzeugleuchte 01 im Bereich 41 vor der Blende 05 komplett frei schwebend wirkt. Alternativ kann der Träger 10 bei einer OLED 20, die ausschließlich entweder eine leuchtende Fläche 21 mit Abstrahlung in zwei Richtungen oder eine leuchtende Fläche 21 mit Abstrahlung in zwei Richtungen und eine oder mehrere Flächen 23, die transparent und nicht abstrahlend sind aufweist, transparent ausgeführt sein.

Die Befestigung der OLED 20 an einem vorzugsweise aus Kunststoff oder aus einem anderen thermisch leitenden Material, wie etwa Aluminium oder einer Aluminiumlegierung hergestellten Träger 10 kann mittels eines Klebers oder speziellen Klebebandes oder einer Klebefolie erfolgen. Durch Verwendung eines geeigneten Klebers oder eines geeigneten Klebebandes können der Träger 10 und die OLED 20 einen anderen thermischen Ausdehnungskoeffizient aufweisen, was durch den entsprechenden Kleber und/oder das entsprechende Klebebande kompensiert werden kann. Insbesondere elastische Kleber und/oder Klebebänder mit elastischen Schichten erfüllen diese Voraussetzungen. Ungeeignet sind Kleber und/oder Klebebänder, bei denen es zu einem Bruch der OLED 20 bzw. eines oder mehrerer deren Glasplättchen und/oder des Trägers 10 und/oder zu einem Ablösen des Klebeverbundes kommen kann.

Ein weiterer Vorteil bei diesem Konzept ist, dass der Halter im Bereich der gesamten Leuchtfläche die OLED 20 stützen kann, zumindest wenn die OLED 20 eine leuchtende Fläche 22 mit Abstrahlung in einer Richtung aufweist. Bei einer Ausführung des Trägers 10 aus transparentem Material ist dies auch möglich, wenn die OLED 20 eine leuchtende Fläche 21 mit Abstrahlung in zwei Richtungen aufweist. Dies führt dazu, dass die beim Betrieb der OLED 20 entstehende Wärme via Wärmeleitung besser von der OLED 20 abgeführt werden kann, als dies bei einer Wärmeübertragung in Verbindung mit einem Wärmeübergang via einer Grenzschicht zu einem die OLED 20 umgebenden, gasförmigen Medium, wie etwa Luft möglich ist. Hierdurch wird die optische Güte des Leuchtmittels nochmals gesteigert, da der Wirkungsgrad der Umwandlung von Elektrizität in Licht auch bei der OLED 20 zumindest oberhalb eines sich beim Betrieb einer OLED 20 einstellenden Temperaturniveaus absinkt. Auch kann mittels einer guten Kühlung mehr Strom in die OLED 20 geschickt werden, wodurch sich die Leuchtdichte der OLED 20 erhöht. Durch die passive Kühlung wird ferner die Lebensdauer der OLED 20 verbessert. Auch führt Wärme bei den organischen Schichten zu einer Alterung und somit einer Reduktion der Leuchtdichte. Durch die ganzflächige Stützung hinter der Leuchtfläche und/oder zumindest hinter einem Teil der Leuchtfläche, beispielsweise hinter dem Teil der Leuchtfläche, den eine leuchtende Fläche 22 mit Abstrahlung in einer Richtung einnimmt und/oder, den eine leuchtende Fläche 21 mit Abstrahlung in zwei Richtungen einnimmt, erfolgt die Alterung der organischen Schichten im gesamten Bereich verzögert und weitestgehend gleichmäßig. Dadurch werden Leuchtdichteunterschiede innerhalb der OLED 20 verringert.

Der Träger 10 kann auch aus einem transparenten Material hergestellt werden, wie etwa aus gegenüber ultravioletter Strahlung stabilem (UV-stabilem) PMMA (PMMA: Polymethylmethacrylat) oder ähnlichem. Dies hat den Vorteil, dass der Träger 10 auch z. B. für transparent ausgeführte OLEDs 20 unsichtbar ausgebildet werden kann. Die Befestigung der OLED 20 am Träger 10 mittels einer Klebung erfolgt hier beispielsweise mittels eines UV-aushärtenden Klebstoff, der vermittels UV-Strahlung, die durch den Träger 10 hindurch oder seitlich am Träger 10 vorbei die Klebeschicht aushärten kann. Vorteilhaft ist hierbei, wenn die organischen Schichten der OLED 20 möglichst nicht von der UV-Strahlung bestrahlt werden, da dies zu einer schnellen Alterung oder ggf. zu einer Zerstörung der Schichten führen kann. Alternativ zum UV-aushärtenden Klebstoff kann ein transparenter Klebstoff oder ein Klebeband verwendet werden.

Die Verwendung eines Trägers 20 aus transparentem Material hat nicht nur designtechnische Vorteile in Verbindung mit transparenten OLEDs 20, sondern auch bei OLEDs 20, die nicht transparent ausgeführt sind, beispielsweise weil sie mit einer Kathode aus z. B. Aluminium oder Silber oder einer derartigen Legierung ausgeführt sind. Solche OLEDs 20 weisen als Leuchtfläche ausschließlich eine leuchtende Fläche 22 mit Abstrahlung in einer Richtung auf. Bei OLEDs 20, deren Leuchtfläche ausschließlich durch eine leuchtende Fläche 22 mit Abstrahlung in einer Richtung gebildet ist, kann die OLED 20 großflächig von deren der Richtung deren Lichtabstrahlung entgegengesetzter Rückseite gestützt werden und der Träger 10 wäre dennoch für einen Betrachter weitestgehend unsichtbar. Auch besteht hierdurch die Möglichkeit, ohne Schädigung der organischen Schicht oder Schichten, da diese durch die metallische Schicht oder Schichten geschützt ist bzw. sind, mit einem UV-aushärtenden (UV: ultraviolette, elektromagnetische Strahlung) Kleber die OLED 20 mit dem Träger 10 zu verbinden.

Die Erfindung stellt damit eine Möglichkeit dar, OLEDs 20 in Kraftfahrzeugleuchten 01 spannungsfrei aufzunehmen. Gleichzeitig können mit dieser Erfindung die Anforderungen an die Halterung hinsichtlich der Anforderungen im Kraftfahrzeug- bzw. Automobilbereich erfüllt werden, wie sie beispielsweise nach dem Standard LV 124 bezüglich mechanischer und thermischer Stabilität vorgegeben sind.

Sich hierdurch ergebende Vorteile sind eine Integrierbarkeit von OLEDs 20 in Kraftfahrzeugleuchten 01.

Mittels der damit für Kraftfahrzeugleuchten 01 erschlossenen OLED-Technologie können schwebende Leuchtflächen in Kraftfahrzeugleuchten 01 integriert werden.

Auch können so lichttechnische Anforderungen besser eingehalten werden.

Die Rückseite 12 des Trägers 10 kann als optisch wirksames Element ausgeführt werden. Dieses kann sowohl beispielsweise durch Metalisieren und/oder Bedampfen hergestellte reflektierende Elemente, als auch brechende und/oder totalreflektierende (TIR; Total Internal Reflection) Elemente umfassen, die beispielsweise aus Plexiglas oder PMMA ähnlich einem Lichtleiter hergestellt sein können und entweder auf der Rückseite 12 des Trägers angeordnet sein können, oder bei Herstellung des Trägers 10 im Zweikomponenten-Spritzgussverfahren oder bei einer Herstellung des Trägers 10 aus vollständig transparentem Material vom Träger 10 umfasst - weil in diesen integriert - sein können.

Indem die Rückseite 12 des Trägers 10 beispielsweise durch eine Metallisierung und/oder durch eine in ein transparentes Material eingearbeitete TIR-Struktur 15 als Reflektor ausgeführt sein kann, kann einer gegenseitigen Abschattung der Leuchtflächen der OLEDs 20 mehrerer hinter- und/oder nebeneinander im Leuchteninnenraum angeordneter Leuchtmittel 100 entgegengewirkt werden (Fig. 7).

Die gegenseitige Abschattung kann ansonsten ein Problem darstellen, wenn die gesetzlichen Lichtwerte im Innen- und/oder Außenbereich bei beispielsweise 80° Außen und/oder +45° Innen zur Fahrzeuglängsachse bei z.B. Heckleuchten nicht erreicht werden. Durch eine Ausführung der Rückseite 12 des Trägers 10 als Reflektor könnten zusätzlich beispielsweise auch extremere Winkelbereiche erreicht werden, wie sie etwa für ein als Erweiterung der Schlusslichtfunktion dienendes Seitenmarkierungslicht nötig sind.

Bei OLEDs 20, die zumindest teilweise eine transparent ausgeführte Leuchtfläche mit wenigstens einer leuchtenden Fläche 21 mit Abstrahlung in zwei Richtungen umfassen, kann ein transparent ausgeführte Träger 10 und/oder die OLED 20 direkt mit transparent ausgeführten Optiken versehen sein und auch direkt der OLED 20 am jeweiligen Träger 10 zugeordnet sein. Dadurch kann auf unterschiedliche Träger 10 für OLEDs 20 mit einer leuchtenden Fläche 21 mit Abstrahlung in zwei Richtungen und für OLEDs 20 mit einer leuchtenden Fläche 22 mit Abstrahlung in einer Richtung verzichtet werden.

Auch hierdurch können beispielsweise im Leuchteninnenraum 04 schwebende Leuchtflächen in eine Kraftfahrzeugleuchte 01 integriert werden. Sofern lichttechnische Werte, wie etwa geometrische Sichtbarkeit durch Abschattung der OLEDs 20 mehrerer, seitlich und/oder hintereinander im Leuchteninnenraum 04 angeordneter Leuchtmittel 100 nicht hinreichend erfüllt werden, stellt die Anordnung reflektierender Strukturen und/oder von Prismen und/oder von TIR-Strukturen 15 auf der Rückseite 12 des Trägers 10 und/oder zumindest auf einer Seite einer leuchtenden Fläche 21 mit Abstrahlung in zwei Richtungen eine Lösungsmöglichkeit dar.

Durch eine entsprechende Wahl der Befestigungsmittel 30 erlaubt die Erfindung auch eine Montage von Leuchtmitteln 100 mit Trägern 10 und von diesen spannungsfrei und thermisch angebunden gehaltenen OLEDs 20 in Kraftfahrzeugleuchten 01, deren von einem Leuchtengehäuse 02 und einer Lichtscheibe 03 zumindest zum Teil umschlossener Leuchteninnenraum 04 von einer Blende 05 in einen durch die Lichtscheibe 03 hindurch gesehen vor der Blende 05 liegenden und durch die Lichtscheibe 03 hindurch einsehbaren, ersten Bereich 41 und in einen durch die Lichtscheibe 03 hindurch gesehen hinter der Blende 05 liegenden und durch die Lichtscheibe 03 hindurch nicht einsehbaren, zweiten Bereich 42 eingeteilt ist, auch bei ungünstigem Verlauf der Blende 05 im Leuchteninnenraum 04 und/oder geringen verbleibenden Bauräumen hinter der Blende 05. Ermöglicht wird dies durch unterschiedliche Montagerichtungen des Trägers 10 des Leuchtmittels 100 mitsamt der vom Träger 10 gehaltenen OLED 20 von vorne oder von hinten in die Blende 05 hinein bzw. durch die Blende 05 hindurch.

Lassen sich beispielsweise die in Fig. 5 bis Fig. 7 dargestellten Leuchtmittel 100 mit deren Trägern 10 und den hiervon gehaltenen OLEDs 20 nicht von hinten in die Blende 05 einbringen, weil es weder für deren als Schraubdom 39 und als Anschlagfläche 38, durch welche hindurch beispielsweise eine Schraube 06 in den Schraubdom 39 eingeschraubt werden muss, ausgeführten Befestigungsmittel 30 keinen Bauraum gibt, und es auch keine Möglichkeit gibt einen Schraubdom 39 vorzuhalten, als auch die in den Fig. 5 und Fig. 6 dargestellten Leuchtmittel 100 mit deren Trägern 10 und den hiervon gehaltenen OLEDs 20 nicht von hinten durch die Blende 05 hindurchschieben lassen, weil hierfür ebenfalls nicht genügend Bauraum zur Verfügung steht, so eignen sich beispielsweise die in Fig. 2 bis Fig. 4 gezeigten Leuchtmittel 100 mit deren Ausführungen des Trägers 10 und der Befestigungsmittel 30, die von der Vorderseite 51 der Blende 05 durch diese hindurch gesteckt und auf der Rückseite 52 der Blende 05 fixiert werden können. In Fig. 7 ist beispielsweise ersichtlich, dass beispielsweise dem Träger 10 des Leuchtmittels 100 ganz links im Leuchteninnenraum 04 der Kraftfahrzeugleuchte 01 nicht genügend Bauraum hinter der Blende 05 zur Verfügung steht, um vom zweiten Bereich 42 aus von der Rückseite 52 der Blende 05 durch die Blende 05 hindurch geschoben werden zu können. Mit einem Leuchtmittel 100 wie in den Fig. 2 bis Fig. 4 dargestellt kann dieses Problem gelöst werden, da dessen Träger 10 von der Vorderseite 51 der Blende 05 aus durch diese hindurch gesteckt und auf der Rückseite frei von einem Schraubdom gehalten wird.

Die mindestens eine von einem Träger 10 gehaltene und als Lichtquelle eines zur Verwendung in einer Kraftfahrzeugleuchte 01 vorgesehenen Leuchtmittels 100 dienende OLED 20 kann alternativ auf drucktechnischem Wege in den Träger 10 integriert oder auf den Träger 10 aufgebracht sein.

So können OLEDs 20 großflächig und kostengünstig beispielsweise auf drucktechnischem Wege hergestellt werden, was bei klassischen LEDs nicht und bei elektronischen Bauelementen und Systemen nur selten der Fall ist. Darüber hinaus müssen OLEDs 20 nicht unbedingt unter teuren Vakuum- und Reinraumbedingungen hergestellt werden. Dies bedeutet eine erhebliche Kosteneinsparung gegenüber anorganischen LEDs. Der Kostenvorteil ergibt sich daraus, dass die elektrisch leitenden farbgebenden Schichten in einem modifizierten Tintenstrahldruckverfahren oder neuerdings auch im Offsetdruck aufgebracht und ebenfalls ohne Vakuum-Aufdampfen anschließend beschichtet werden können. Dadurch können OLEDs 20 einfach, beispielsweise bevorzugt auf drucktechnischem Wege beispielsweise bei in einem von einem Leuchtengehäuse 02 und einer Lichtscheibe 03 zumindest teilweise umgebenen Leuchteninnenraum 04 einer Kraftfahrzeugleuchte 01 beherbergten Leuchtmittel 100 auf die zumindest einer Lichtscheibe 03 zugewandten Vorderseite 13 des Trägers 10 des Leuchtmittels 100 aufgebracht werden. Im Falle eines mehrschichtigen oder mehrschichtig hergestellten Trägers 10 können OLEDs auf drucktechnischem Wege auf eine erste Schicht des Trägers 10 aufgebracht werden, um im Anschluss hieran, beispielsweise im Spritzgussverfahren oder durch Aufkleben, mit einer weiteren Schicht des Trägers 10 bedeckt und hermetisch eingeschlossen zu werden. Zumindest die eine OLED 20 in einer Richtung bedeckende Schicht ist dabei transparent ausgeführt.

Alternativ kann die mindestens eine auf oder in einem Träger 10 des Leuchtmittels 100 angeordnete oder untergebrachte OLED 20 mittels eines bei der Herstellung einer OLED 20 verwendeten Verfahrens aufgebracht und/oder appliziert sein.

Dabei stehen zwei verschiedene Ansätze für die Herstellung von OLEDs zur Verfügung. Einerseits können vermittels Vakuumdeposition kleinere Moleküle durch Verdampfen auf einer Oberfläche einer als Substrat für die OLED 20 dienenden, fertig hergestellten oder erst zum Teil, weil beispielsweise mehrschichtigen, hergestellten Träger 10 eines Leuchtmittels 100 abgeschieden werden, Entsprechend dem Aufdampfen auf die bereits mehrfach erwähnten Glasplättchen. Die Vakuumdeposition wird derzeit hauptsächlich angewendet und ermöglicht es, OLEDs 20 mit sehr reinen und definierten Schichtarchitekturen herzustellen. Nachteilig an der Die Vakuumdeposition sind mit hohe Kosten für die benötigten Ausgangsmaterialien und dass der Preis und der Aufwand für die Herstellung großflächiger OLEDs 20 überproportional ansteigt. Typische Drücke bei der Vakuumdeposition liegen im Bereich von 10 bis 8 mbar.

Die Skalierung vom Labormaßstab auf eine Massenproduktion ist bei der Vakuumdeposition besonders schwierig. Ein weiterer Nachteil ist der hohe Materialbedarf. Die Abscheidung erfolgt unspezifisch, in der Regel wird das gesamte Innenleben der Verdampfungsapparaturen mit den teuren Ausgangsmaterialien beschichtet. Obwohl eigentlich nur winzige Mengen an Material benötigt werden, ist diese Art der Herstellung von OLEDs 20 mit großen Verlusten verbunden. Die erforderliche regelmäßige Entfernung des unerwünscht im Inneren der Anlagen abgeschiedenen Materials nach nur wenigen Produktionszyklen erschwert eine kontinuierliche Produktion und verkompliziert die Herstellung entsprechend zusätzlich.

Ein alternativer Ansatz für die Herstellung von OLEDs 20 nutzt nasschemische Abscheidungsverfahren, wie etwa Druck- und Beschichtungsprozesse (vgl. Arias, A. C. et Al.: «Materials and Applications for Large Area Electronics: Solution-Based Approaches», 2010, Chemical Reviews, 110, 3; Duan, L. et Al.: «Solution processable small molecules for organic light-emitting diodes», 2010, Journal of Materials Chemistry, 20, 6392; Zhong, C. et Al.: «Materials and Devices toward Fully Solution Processable Organic Light-Emitting Diodes», 2011, Chemistry of Materials, 23, 326).

Im Gegensatz zur Vakuumdeposition sind diese kostengünstiger und ermöglichen einen höheren und damit schnelleren Durchsatz. Außerdem sind sie zur Erzeugung von großflächigen OLEDs 20 deutlich besser geeignet. Die Modifikation bestehender Verfahren wie Schlitzguß, Spin-Coating, Tiefdruck, Siebdruck oder Inkjetdruck ermöglicht den Einsatz von löslichen Materialien, und hier vor allem Polymere, aber auch Übergangsmetallkomplexe.

Alternativ ist denkbar, dass die mindestens eine auf oder in einem Träger 10 des Leuchtmittels 100 angeordnete oder untergebrachte OLED 20 durch Aufkleben oder durch Laminieren aufgebracht und/oder appliziert ist.

Eine zusätzliche Möglichkeit ergibt sich dadurch, dass die mindestens eine auf oder in einem Träger 10 des Leuchtmittels 100 angeordnete oder untergebrachte OLED 20 durch Einspritzen zwischen zwei Schichten im Spritzgussverfahren in den Träger 10 03 integriert ist.

Beispielsweise kann mindestens eine OLED 20 eine in dem fertigen Träger 10 innen liegende Innenfläche bilden, indem die OLED 20 auf eine Oberfläche eines noch nicht fertig gestellten, mehrschichtige oder in einem mehrstufigen Herstellungsprozess hergestellten Trägers 10 beispielsweise auf drucktechnischen Wege oder durch Aufkleben oder durch Laminieren oder mittels eines bei der Herstellung einer OLED 20 verwendeten Verfahrens aufgebracht und/oder appliziert wird, welche Oberfläche im Anschluss hieran beispielsweise durch das Aufbringen mindestens einer weiteren Schicht versiegelt und dadurch gegenüber der Umgebung hermetisch abgedichtet ist und dadurch eine Innenfläche in dem fertigen Träger 10 bildet, welche sich an der Grenze zwischen der Schicht des Trägers 10, auf welche die OLED 20 aufgebracht und/oder appliziert ist, und der diese überdeckenden Schicht befindet. Dieses Aufbringen einer weiteren Schicht erfolgt beispielsweise im Spritzgussverfahren, wodurch die mindestens eine OLED 20 in dem fertigen Träger 10 eingespritzt sein kann.

Der Träger 10 kann tiefgezogen oder im Spritzgussverfahren hergestellt sein.

Um den Träger 10 tiefzuziehen oder im Spritzguss herstellen zu können, ist der Träger 10 bevorzugt aus einem Kunststoff hergestellt.

Der Träger 10 ist bevorzugt transparent und klar ausgeführt.

Der Träger 10 kann plan oder zwei- oder dreidimensional gewölbt ausgeführt sein.

Wenigstens einer Lichtquelle eines Leuchtmittels der Kraftfahrzeugleuchte 01 können ein oder mehrere zur Ausformung einer Lichtverteilung beitragende Optikelemente zur Lichtlenkung zugeordnet sein. So kann beispielswiese mindestens einem in einem von einem Leuchtengehäuse 02 und einer Lichtscheibe 03 zumindest zum Teil umschlossenen Leuchteninnenraum 04 der Kraftfahrzeugleuchte 01 beherbergten und zur Erfüllung zumindest einer Lichtfunktion der Kraftfahrzeugleuchte 01 vorgesehenen Leuchtmittel 100 mit zumindest einer von einem Träger 10 gehaltenen OLED 20 als Lichtquelle ein Optikelement beispielsweise in Form eines Reflektors zugeordnet sein.

Alternativ oder zusätzlich kann die Lichtscheibe 03 selbst als mindestens ein Optikelement ausgebildet sein und/oder mindestens ein Optikelement umfassen, beispielsweise indem sie vorzugsweise an deren Innenseite mit einer zur Erzeugung einer oder mehrerer eingangs erwähnter Lichtverteilungen beitragenden optischen Struktur versehen ist. Hierdurch kann eine ansonsten gegebenenfalls vorgesehene, im Strahlengang des Lichts zwischen der Lichtquelle beispielsweise mindestens eines in einem von einem Leuchtengehäuse 02 und der Lichtscheibe 03 zumindest zum Teil umschlossenen Leuchteninnenraum 04 der Kraftfahrzeugleuchte 01 beherbergten und zur Erfüllung zumindest einer weiteren Lichtfunktion der Kraftfahrzeugleuchte 01 vorgesehenen weiteren Leuchtmittels und der Lichtscheibe 03 angeordnete Optikscheibe verzichtet werden. Dadurch kann auch bei anderen Lichtquellen, als der mit dem Träger 10 kombinierten OLEDs 20, die optische Güte deren Beitrags zur Erfüllung einer Lichtfunktion der Kraftfahrzeugleuchte 01 durch den möglichen Verzicht auf optische Übergänge gesteigert werden.

Die Lichtscheibe 03 kann weitere optisch relevante Geometrien, auch für Lichtquellen andere Lichtfunktionen der Kraftfahrzeugleuchte 01 erfüllender Leuchtmittel aufweisen und/oder umfassen. Die Geometrien können alternativ oder zusätzlich vorgesehen sein, um das Warm-/Kalterscheinungsbild der Kraftfahrzeugleuchte 01 bei ein- bzw. ausgeschaltetem Leuchtmittel zu beeinflussen.

Beispiele optisch relevanter Geometrien sind in die Lichtscheibe 03 integrierte oder von der Lichtscheibe 03 umfasste Optikelemente beispielsweise in Form einer vorzugsweise an der dem Leuchteninnenraum zugewandten Innenseite der Lichtscheibe 03 vorgesehenen optischen Struktur, welche zur Erzeugung einer oder mehrerer eingangs erwähnter Lichtverteilungen beiträgt.

Weitere Beispiele optisch relevanter Geometrien sind:
- mit in die Lichtscheibe 03 integrierte (Mikro-) Optiken eines Rückstrahlers, und/oder
- mit in die Lichtscheibe 03 integrierte transparente, brechende und/oder streuende Walzenoptiken für eine dahinterliegende Bremslichtfunktion, wobei einige Walzen auf bzw. unter der Oberfläche eine oder mehrere OLEDs 20 beinhalten können.

Die Erfindung ist insbesondere im Bereich der Herstellung von Kraftfahrzeugleuchten gewerblich anwendbar.

### Bezugszeichenliste

- 01: Kraftfahrzeugleuchte
- 02: Leuchtengehäuse
- 03: Lichtscheibe
- 04: Leuchteninnenraum
- 05: Blende
- 06: Schraube
- 10: Träger
- 11: Lichtöffnung
- 12: Rückseite des Trägers 10
- 13: Vorderseite des Trägers 10
- 14: Befestigungsfläche
- 15: TIR-Struktur
- 20: OLED
- 21: Fläche mit Abstrahlung in zwei Richtungen (Fläche der Kategorie A)
- 22: Fläche mit Abstrahlung in einer Richtung (Fläche der Kategorie B)
- 23: Fläche (transparent und nicht abstrahlend; Kategorie C1)
- 24: Fläche (weder abstrahlend noch transparent; Kategorie C2)
- 30: Befestigungsmittel
- 31: durch die Blende 05 hindurchreichende Partie des Trägers 10
- 32: Auskragung an der Rückseite 52 der Blende 05
- 33: Klammer
- 34: Kerbe
- 35: Klammer
- 36: Kerbe
- 37: Abstützarm
- 38: Anschlagfläche
- 39: Schraubdom
- 41: erster Bereich des Leuchteninnenraums 04, vor der Blende 05 liegend
- 42: zweiter Bereich des Leuchteninnenraums 04, hinter der Blende 05 liegend
- 51: Vorderseite der Blende 05
- 52: Rückseite der Blende 05
- 100: Leuchtmittel
- 200: Temperierelement
- 210: Temperatursensor
- 220: Schaltkreis

## Patentansprüche

1. Leuchtmittel (100) umfassend mindestens eine OLED (20) als Lichtquelle, **gekennzeichnet durch** mindestens ein mit wenigstens einer OLED (20) des Leuchtmittels (100) in zumindest wärmeleitendem Kontakt stehendes Temperierelement (200).

2. Leuchtmittel nach Anspruch 1, wobei mindestens ein Temperierelement (200) elektrisch betrieben ist.

3. Leuchtmittel nach Anspruch 1 oder 2, wobei das mindestens eine Temperierelement (200) mindestens ein Heizelement und/oder mindestens ein Kühlelement umfasst.

4. Leuchtmittel nach Anspruch 1, 2 oder 3, wobei ein mit wenigstens einer OLED (20) des Leuchtmittels (100) in zumindest wärmeleitendem Kontakt stehender Temperatursensor (2210) vorgesehen ist, der ein einer von ihm erfassen Temperatur proportionales Ausgangssignal erzeugt.

5. Leuchtmittel nach Anspruch 4, wobei ein mit dem Temperatursensor (210) verbundener Schaltkreis (220) vorgesehen ist, der vom Ausgangssignal des Temperatursensors (210) gesteuert wird, und mit dem Temperierelement (200) verbunden ist und dessen Betrieb und/oder Stromzufuhr steuert.

6. Leuchtmittel nach Anspruch 5, wobei der Schaltkreis (220) einen Schalter umfasst, welcher bei einem einer von dem Temperatursensor (210) erfassten Temperatur, die kleiner ist, als eine vorgegebene Schwellentemperatur proportionalen Ausgangssignal derart geschaltet wird, dass ein vom Temperierelement (200) umfasstes Heizelement dann betrieben wird und hiermit die mindestens eine mit dem Temperierelement (200) zumindest in wärmeleitendem Kontakt stehende OLED (20) beheizt wird, und welcher bei einem einer von dem Temperatursensor (210) erfassten Temperatur, die größer ist, als eine vorgegebene Schwellentemperatur proportionalen Ausgangssignal derart geschaltet wird, dass das vom Temperierelement (200) umfasste Heizelement dann nicht betrieben wird und hiermit die mindestens eine mit dem Temperierelement (200) zumindest in wärmeleitendem Kontakt stehende OLED (20) nicht beheizt wird.

7. Leuchtmittel nach Anspruch 5 oder 6, wobei der Schaltkreis (220) einen Proportionalregler umfasst, der ein vom Temperierelement (200) umfasstes Heizelement unterhalb einer vorgegebenen Schwellentemperatur um so stärker betreibt, je niedriger die vom Temperatursensor (210) erfasste Temperatur ist, und dadurch dessen Heizwirkung steigert, je niedriger die vom Temperatursensor (210) erfasste Temperatur ist.

8. Leuchtmittel nach Anspruch 5, 6 oder 7, wobei der Schaltkreis (220) einen Schalter umfasst, welcher bei einem einer von dem Temperatursensor (210) erfassten Temperatur, die größer ist, als eine vorgegebene Schwellentemperatur proportionalen Ausgangssignal derart geschaltet wird, dass ein vom Temperierelement (200) umfasstes Kühlelement dann betrieben wird und hiermit die mindestens eine mit dem Temperierelement (200) zumindest in wärmeleitendem Kontakt stehende OLED (20) gekühlt wird, und welcher bei einem einer von dem Temperatursensor (210) erfassten Temperatur, die kleiner ist, als eine vorgegebene Schwellentemperatur proportionalen Ausgangssignal derart geschaltet wird, dass das vom Temperierelement (200) umfasste Kühlelement dann nicht betrieben wird und hiermit die mindestens eine mit dem Temperierelement (200) zumindest in wärmeleitendem Kontakt stehende OLED (20) nicht gekühlt wird.

9. Leuchtmittel nach einem der Ansprüche 5 bis 8, wobei der Schaltkreis (220) einen Proportionalregler umfasst, der ein vom Temperierelement (200) umfasstes Kühlelement oberhalb einer vorgegebenen Schwellentemperatur um so stärker betreibt, je höher die vom Temperatursensor (210) erfasste Temperatur ist, und dadurch dessen Kühlwirkung steigert, je höher die vom Temperatursensor (210) erfasste Temperatur ist.

10. Leuchtmittel nach einem der Ansprüche 5 bis 9, wobei der Schaltkreis (220) ein oder mehrere Proportional- und/oder Differential- und/oder Integralglieder (P-, D-, I-Glieder) und/oder Schalter umfasst um eine gewünschte Regelcharakteristik des Temperierelements zu erhalten.

11. Leuchtmittel nach einem der voranstehenden Ansprüche, wobei ein Temperierelement und/oder ein gegebenenfalls vorgesehener Temperatursensor (210) unmittelbar auf der OLED (20) angeordnet sind.

12. Leuchtmittel nach einem der voranstehenden Ansprüche, wobei das Leuchtmittel (100) zusätzlich einen Träger (10) umfasst, an dem die mindestens eine OLED (20) des Leuchtmittels (100) und das zumindest in wärmeleitendem Kontakt mit der OLED stehende Temperierelement (200) und/oder ein gegebenenfalls vorgesehener, zumindest in wärmeleitendem Kontakt mit der OLED stehender Temperatursensor (210) angeordnet sind, wobei das Temperierelement (200) auf und/oder in dem mit der mindestens einen OLED (20) verbundenen Träger (10) und/oder zwischen dem Träger (10) und der OLED (20) und/oder auf einer der OLED (20) abgewandten Seite des Trägers (10) angeordnet ist.

13. Kraftfahrzeugleuchte (01) mit wenigstens einem zur Erfüllung wenigstens einer Lichtfunktion der Kraftfahrzeugleuchte (01) vorgesehenen Leuchtmittel (100) mit wenigstens einer OLED (20) als Lichtquelle, **gekennzeichnet durch** ein Leuchtmittel (100) nach einem der vorhergehenden Ansprüche.

14. Kraftfahrzeugleuchte nach Anspruch 13, wobei in einem von einem Leuchtengehäuse (02) und wenigstens einer Lichtscheibe (03) zumindest zum Teil umschlossenen Leuchteninnenraum (04) eine oder mehrere Lichtquellen:
- des selben Leuchtmittels (100) beherbergt sind, wie das Leuchtmittel (100), welches die mindestens eine mit dem mindestens einen Temperierelement (200) zumindest in wärmeleitendem Kontakt stehende OLED (20) umfasst, und/oder
- mindestens eines zur Erfüllung der selben Lichtfunktion vorgesehenen Leuchtmittels beherbergt sind, wie der von dem die mit dem mindestens einen Temperierelement (200) zumindest in wärmeleitendem Kontakt stehende OLED (20) umfassenden Leuchtmittel (100) erfüllten, und/oder
- mindestens eines weiteren Leuchtmittels beherbergt sind, als dem Leuchtmittel (100), welches die mindestens eine mit dem mindestens einen Temperierelement (200) zumindest in wärmeleitendem Kontakt stehende OLED (20) umfasst, und/oder
- mindestens eines zur Erfüllung einer anderen Lichtfunktion vorgesehenen Leuchtmittels beherbergt sind, als der von dem die mindestens eine mit dem mindestens einen Temperierelement (200) zumindest in wärmeleitendem Kontakt stehende OLED (20) umfassenden Leuchtmittel (100) erfüllten.

15. Kraftfahrzeugleuchte nach Anspruch 13 oder 14, wobei sie als Heckleuchte oder als in einem Außenrückblickspiegel untergebrachte Leuchte ausgeführt ist.
